# EUROPÄISCHE PATENTSCHRIFT

(11) **EP 4 104 036 B1**
(45) Veröffentlichungstag und Bekanntmachung des Hinweises auf die Patenterteilung: **27.11.2024**
(21) Anmeldenummer: 21710191.4
(22) Anmeldetag: 15.02.2021
(51) Int. Cl.: G06F 3/01, G06F 1/16, H04B 1/3888, H04M 1/04, H01H 19/04, H01H 19/14, H04M 1/72409, H04M 1/7246, G05G 5/03, G06F 3/0362, A45C 11/00, H01H 19/00, H01H 25/00, H03K 17/97, H04M 1/18, H04M 1/23, F16F 9/53, G05G 1/08, H01H 19/11, H01H 3/00

(54) **HÜLLENEINRICHTUNG FÜR EIN MOBILGERÄT UND MOBILGERÄT**
SLEEVE ARRANGEMENT FOR A MOBILE DEVICE AND MOBILE DEVICE
SYSTÈME DE COQUE POUR APPAREIL MOBILE ET APPAREIL MOBILE

(30) Priorität: 14.02.2020 DE 102020104011; 21.02.2020 DE 102020104705; 26.06.2020 DE 102020116941
(43) Veröffentlichungstag der Anmeldung: 21.12.2022
(73) Patentinhaber: INVENTUS Engineering GmbH, 6771 St. Anton i.M. (AT)
(72) Erfinder: BATTLOGG, Stefan, 6771 St. Anton i.M. (AT)
(74) Vertreter: BSB Patentanwälte Schütte & Engelen Partnerschaft mbB
(86) Internationale Anmeldenummer: PCT/EP2021/053689
(87) Internationale Veröffentlichungsnummer: WO 2021/160897

(56) Entgegenhaltungen:
- EP-A1- 3 317 749
- WO-A1-2013/163233
- US-A1- 2006 033 703
- US-A1- 2015 268 724
- US-A1- 2016 103 489
- US-A1- 2016 123 059
- US-A1- 2018 049 336
- US-B1- 10 560 558
- US-B1- 9 862 099

## Beschreibung

Die vorliegende Erfindung betrifft eine Hülleneinrichtung für ein Mobilgerät mit wenigstens einer Eingabeeinrichtung und ein Mobilgerät mit wenigstens einer Eingabeeinrichtung.

Solche Mobilgeräte sind zum Beispiel Handhelds (wie Smartphones, faltbare Smartphones oder Tablets bzw. Touch Pads) oder andere Arten von Smart Devices (wie zum Beispiel eine Smart Watch) oder auch Notebooks, faltbare Notebooks oder dergleichen. Ein besonders entscheidendes Merkmal solcher Geräte ist deren Größe und Kompaktheit. Daher weisen beispielsweise gegenwärtige Smartphones oder Tablets nur noch sehr wenige oder gar keine Druckknöpfe bzw. Schalter auf. In der Regel erfolgt die Bedienung nahezu ausschließlich über ein berührungsempfindliches Display. Das wirkt sich allerdings nachteilig auf den Bedienkomfort aus. Beispielsweise muss während der Bedienung auch immer das Display beobachtet werden muss. Zudem muss das Display zum Bedienen dann auch stets aktiv sein. Mitunter wird es auch als unkomfortabel angesehen, dass das Gerät bei der Bedienung in bestimmter Weise mit den Händen gehalten werden muss.

Das Dokument US 2006/0033703 A1 offenbart ein Mobilgerät mit einem Scrollrad, das mittels einer elektromagnetischen Bremseinrichtung gezielt dämpfbar ist. Das Dokument WO 2013/0163233 A1 offenbart eine Hülleneinrichtung für ein Mobilgerät mit einer aufklemmbaren Eingabeeinrichtung wie z.B. ein Scrollrad oder ein vibrierender Joystick. Das Dokument US 9,862,099 B1 offenbart einen haptischen handgeführten Controller der einen Drehregler, einen Motor für das erzeugen von Kraftrückkopplung und Berührungssensoren umfasst.

Es sind Mobiltelefone bekannt geworden, die über einen Radarscanner oder Bilderkennung verfügen und berührungslos Gesten z. B. der Hand eines Benutzers erkennen können. Eine derartige Bedienung funktioniert an sich, erfordert aber ein entsprechendes Erkennungssystem wie einen Radar-Chip in dem Mobilgerät und eignet sich bislang nur für einfache Befehle.

Es ist daher die Aufgabe der vorliegenden Erfindung, die Bedienbarkeit und insbesondere den Bedienkomfort von solchen Mobilgeräten zu verbessern. Vorzugsweise soll eine zuverlässige und gezielte Bedienung auch ohne eine visuelle Beobachtung des Geräts bzw. des Displays möglich sein. Vorzugsweise soll eine einfache, aber auch vielfältige manuelle Bedienung ermöglicht werden, vorzugsweise auch mit Handschuhen. Insbesondere soll eine Verbesserung bei bereits vorhandenen Mobilgeräten möglich sein, d.h. unter anderen der Bedienkomfort und die Bedienkomplexität verbessert werden. Vorzugsweise soll eine Lösung aber auch im Rahmen der Herstellung in ein Mobilgerät integriert werden können. Insbesondere ist es wünschenswert, dass dabei die Kompaktheit der Mobilgeräte nicht ungünstig beeinflusst wird. Diese Aufgabe wird gelöst durch eine Hülleneinrichtung mit den Merkmalen des Anspruchs 1 sowie durch ein Mobilgerät mit den Merkmalen des Anspruchs 15. Bevorzugte Weiterbildungen der Erfindung sind Gegenstand der Unteransprüche. Weitere Vorteile und Merkmale der Gerätekomponente mit einer magnetorheologischen Bremseinrichtung ergeben sich aus der allgemeinen Beschreibung und der Beschreibung der Ausführungsbeispiele.

Beispielsweise ist eine Hülleneinrichtung für ein Mobilgerät und insbesondere für ein Smartphone, faltbares Smartphone oder Tablet (iPad, Note...)oder für andere Arten von Handhelds bzw. mobilen Smart Devices vorgesehen. Die Hülleneinrichtung umfasst wenigstens ein Hüllenteil zum wenigstens abschnittsweisen Umgeben des Mobilgeräts. Das Mobilgerät ist wenigstens teilweise in bzw. an dem Hüllenteil aufnehmbar. Die Hülleneinrichtung umfasst wenigstens eine wenigstens teilweise in dem Hüllenteil angeordnete Eingabeeinrichtung zur Ansteuerung des in dem Hüllenteil aufnehmbaren bzw. aufgenommenen Mobilgeräts. Dadurch kann das Mobilgerät von dem Hüllenteil aus bedient werden. Dabei umfasst die Eingabeeinrichtung wenigstens ein bewegbares Bedienelement und wenigstens eine Bremseinrichtung. Dabei ist wenigstens eine (im Rahmen der Bedienung durchgeführte) Bewegung des Bedienelement mittels der Bremseinrichtung gezielt dämpfbar.

Die erfindungsgemäße Hülleneinrichtung bietet viele Vorteile. Einen erheblichen Vorteil bietet das gezielt dämpfbare Bedienelement der Eingabeeinrichtung. So kann ein Mobilgerät und beispielsweise ein Smartphone oder Tablet unaufwendig und einfach mit einem weiteren Bedienelement ausgestattet werden, welches sehr umfangreiche und zugleich komfortable und besonders intuitive Bedienmöglichkeiten bietet. Aufgrund der zum Beispiel insbesondere magnetorheologischen Dämpfung kann die Erfindung besonders vorteilhaft zum Ansteuern von verschiedensten Gerätefunktionen und beispielsweise Applikationen eingesetzt werden. Bestimmten Geräte- bzw. Eingabefunktionen können passende haptische Feedbacks zugeordnet werden, wodurch der Nutzer rein aus dem Feedback rückschließen kann, was er einstellt und in welche Bedienrichtung. Z. B. kann das Drehmoment beim Drehen in Uhrzeigerichtung zunehmen, wenn die Mikrofonaufnahmelautstärke lauter eingestellt wird. Dies ohne Hinsehen (also durch "Blindbedienung"). Möglich und besonders bevorzugt ist auch der Einsatz einer motorischen Bremseinrichtung.

Ein weiterer besonderer Vorteil der Erfindung ist, dass nicht nur Eingaben vom Benutzer zum Mobilgerät, sondern auch haptische Rückmeldungen vom Mobilgerät an den Benutzer erfolgen können. Die Hülleneinrichtung mit dem manuell fühlbaren Bedienelement erlaubt eine sehr direkte und unmittelbar mit dem Finger fühlbare Rückkopplung. Dadurch kann eine sehr genaue Steuerung durchgeführt werden. Durch den direkten Kontakt mit einem Finger der Hand, der auch mit einem Handschuh versehen sein kann, wird eine feinfühlige und intuitive Steuerung möglich.

Zugleich ist es mit der Erfindung besonders einfach möglich, all diese Vorteile auch bei einem bereits vorhandenen Mobilgerät nutzen zu können. Beispielsweise wird dazu das Smartphone oder Tablet einfach in das Hüllenteil eingesetzt und mit der Hülleneinrichtung gekoppelt, beispielsweise drahtlos über Bluetooth, Ant+, ZigBee oder dergleichen. Nach der Kopplung können dann beispielsweise durch Drehen des Bedienelements Funktionen gestartet, eingestellt oder beendet werden. Dabei kann vorteilhafterweise eine mechanische bzw. manuelle Betätigung erfolgen, ohne dass die Augen längere Zeit auf das Display gerichtet werden müssen.

Besonders bevorzugt ist die Bremseinrichtung magnetorheologisch ausgebildet und/oder umfasst wenigstens eine magnetorheologische Bremseinrichtung. Eine oder die magnetorheologische Bremseinrichtung umfasst wenigstens ein magnetorheologisches Medium und wenigstens eine Felderzeugungseinrichtung zur Erzeugung und Steuerung einer magnetischen und/oder elektrischen Feldstärke. Mittels der bzw. einer Felderzeugungseinrichtung ist das rheologische (insbesondere das magnetorheologische) Medium vorzugsweise beeinflussbar, um das Drehmoment für die Drehbarkeit des Bedienelements einzustellen. Eine magnetorheologische Bremseinrichtung bietet besonders viele Vorteile.

Insbesondere umfasst die Hülleneinrichtung wenigstens eine Steuereinrichtung zur Ansteuerung der Bremseinrichtung. Mittels der Steuereinrichtung kann die mit der Bremseinrichtung erzeugte Dämpfung insbesondere gezielt angepasst werden.

Insbesondere wird zur Ansteuerung des Mobilgeräts eine Betätigungsstellung des Bedienelements, vorzugsweise eine Winkelstellung und besonders bevorzugt eine Drehwinkelstellung, berücksichtigt. Insbesondere erfolgt die Eingabe bzw. Ansteuerung des Mobilgeräts in Abhängigkeit der Betätigungsstellung. Insbesondere ist dazu einem definierten Winkel wenigstens eine bestimmte Eingabe bzw. Ansteuerung des Mobilgeräts zugeordnet. Im Rahmen der vorliegenden Erfindung kann ein Winkel auch durch einen Winkelbereich bereitgestellt werden.

Beispielsweise erfolgt eine erste Eingabe dadurch, dass das Bedienelement bis zu einem ersten Drehwinkel bzw. in einen ersten Drehwinkelbereich gedreht wird. Eine zweite Eingabe erfolgt dann durch Drehen des Bedienelements bis zu einem zweiten Winkel bzw. in einen zweiten Drehwinkelbereich. Dabei kann die hier vorgestellte Eingabeeinrichtung vorzugsweise wenigstens 30.000 Inkremente bzw. unterscheidbare Drehwinkel pro Umdrehung bereitstellen. Dabei kann den Inkrementen bzw. Drehwinkeln vorzugsweise jeweils wenigstens eine Eingabe zugeordnet werden. Die Einteilung und die Zuordnung von Inkrement bzw. Winkel zu einer Eingabe erfolgt dann insbesondere in Abhängigkeit der jeweiligen Gerätefunktion und z. b. abhängig von einer App. Insbesondere kann diese Zuordnung dynamisch angepasst werden. Ergänzend können auch eine Geschwindigkeit und/oder Richtung der Betätigung des Bedienelements und/oder die Zeit für diese Zuordnung berücksichtigt werden. Beispielsweise kann durch schnelleres Drehen eine andere Eingabe als bei einem langsameren Drehen erfolgen. Beim langsamen Drehen kann eine feine Rasterung (= hohes/niederes Drehmoment mit geringen Winkelabständen) zielführend sein, da etwas präzise eingestellt/justiert werden muss. Beim schnellen Drehen, vorzugsweise ohne Rasterung oder mit einer ganz geringen Rasterung, können große Einstell- oder Verstellbereiche schnell und mit geringer Kraft am Finger (Drehmoment am Bedienelement) durchfahren werden. Das bietet eine sehr hoch aufgelöste und zugleich besonders einfache Bedienung. Es ist bevorzugt, dass das Bedienelement mehrfach und insbesondere kontinuierlich gedreht werden kann. Es ist auch möglich, dass der Drehwinkel begrenzt ist und auf eine gewisse Anzahl von Umdrehungen oder auf einen Winkelbereich einer Umdrehung beschränkt ist. Es ist auch möglich, dass das Drehmoment in eine Drehrichtung anders wie in die andere Drehrichtung (Uhrzeigersinn bzw. gegen den Uhrzeigersinn) ist. So kann der Nutzer klar die Drehrichtung bzw. Einstellrichtung haptische erkennen und zuordnen.

Vorzugsweise umfasst die Hülleneinrichtung wenigstens eine Sensoreinrichtung. Vorzugsweise ist eine Betätigungsstellung des Bedienelements mittels der Sensoreinrichtung erfassbar. Die Betätigungsstellung des Bedienelements ist insbesondere durch eine Winkelstellung und vorzugsweise durch eine Drehwinkelstellung definiert. Die Betätigungsstellung kann direkt oder indirekt erfasst werden.

Insbesondere ist die Bremseinrichtung mittels der Steuereinrichtung wenigstens in Abhängigkeit der Betätigungsstellung des Bedienelements ansteuerbar. Insbesondere ist die Steuereinrichtung dazu geeignet und ausgebildet, die Dämpfung der Bewegung des Bedienelements und insbesondere ein Verzögerungsmoment der Bremseinrichtung in Abhängigkeit der Betätigungsstellung einzustellen und vorzugsweise gezielt anzupassen. Es ist möglich und bevorzugt, dass je nach Betätigungsstellung des Bedienelements eine andere Dämpfung und insbesondere ein definiertes Verzögerungsmoment eingestellt werden kann.

Das bei einer bestimmten Betätigungsstellung eingestellte Verzögerungsmoment kann beispielsweise fest vorgegeben sein und/oder dynamisch durch einen Algorithmus bestimmt werden. Die Zuordnung von Betätigungsstellung und Verzögerungsmoment kann beispielsweise davon abhängen, welche Gerätefunktion und beispielsweise welche Applikation gerade bedient wird. Die Zuordnung kann zusätzlich oder alternativ auch von einer Bewegungsgeschwindigkeit des Bedienelements und/oder der Zeit und/oder einer Betätigungskraft und/oder einer Bewegungsrichtung abhängen. Dabei kann die Steuereinheit auch lernfähig sein (Künstliche Intelligenz, Maschinenlernen). Bestimmte Bedienungen oder Bedienabläufe (Bedienmuster) können so optimiert oder zugeordnet werden. Hat der Nutzer - über längere Zeit betrachtet - bevorzugte Bedienmuster, so kann sich das Bedienelement darauf einstellen und kann eine Funktion schon automatisiert und im Vorhinein übernehmen. Durch das entsprechende haptische Feedback, welches den Funktionen zugeordnet ist, weiß der Nutzer auch, was gerade verstellt wird und kann bei Fehlvorgaben entsprechend reagieren.

Vorzugsweise ist die Dämpfung in Abhängigkeit wenigstens eines mittels der Sensoreinrichtung erfassten Drehwinkels des Bedienelements einstellbar. Die Dämpfung wird insbesondere in Abhängigkeit des Drehwinkels angepasst.

Vorzugsweise ist die Steuereinrichtung dazu geeignet und ausgebildet, die Bremseinrichtung wenigstens (auch) in Abhängigkeit wenigstens eines Steuerbefehls anzusteuern. Vorzugsweise ist die Steuereinrichtung dazu geeignet und ausgebildet, den Steuerbefehl in wenigstens ein an dem Bedienelement wahrnehmbares haptisches Signal umzusetzen. Das erfolgt insbesondere derart, dass ein Benutzer als Folge einer vorgenommenen Eingabe und/oder während einer Eingabe wenigstens eine haptische Rückmeldung (sog. Force Feedback) erhalten kann oder erhält. Das haptische Signal umfasst insbesondere eine definierte Abfolge von Verzögerungsmomenten oder ist als eine solche ausgebildet. Insbesondere wird unter einem haptischen Signal eine wesentliche (und insbesondere wahrnehmbare) Veränderung des Drehwiderstands verstanden.

Der Steuerbefehl gibt insbesondere vor, welches Verzögerungsmoment bei welchem Drehwinkel und/oder zu welcher Zeit einzustellen ist. Der Steuerbefehl kann wenigstens eine Funktion umfassen, welche einen Momentenverlauf über den Drehwinkel und/oder über die Zeit beschreibt. Der Steuerbefehl kann Informationen darüber enthalten, wie eine solche Funktion dynamisch anzupassen ist.

Der Steuerbefehl wird vorzugsweise von dem Mobilgerät und insbesondere von einer in dem Mobilgerät hinterlegten Applikation (App) oder auch einem entfernten Server oder einem anderen Mobilgerät bereitgestellt. Eine Applikation (auch App genannt) ist vorzugsweise ein Programm, welches wenigstens teilweise auf dem Mobilgerät ausführbar ist. Die Applikation kann auch auf einem entfernten Computer hinterlegt sein, der Steuerbefehle an das Mobilgerät ausgibt, die dann lokal ausgeführt werden. Der Steuerbefehl kann auch von der Steuereinrichtung selbst bereitgestellt werden. Die Steuereinrichtung und/oder das Mobilgerät können insbesondere eine Vielzahl von unterschiedlichen Steuerbefehlen erzeugen oder aus einer Vielzahl von hinterlegten Steuerbefehlen gezielt einen Steuerbefehl auswählen.

Die Eingabeeinrichtung ist vorzugsweise drahtlos und/oder drahtgebunden mit dem Mobilgerät koppelbar. Insbesondere ist die Eingabeeinrichtung derart koppelbar, dass das in dem Hüllenteil aufgenommene Mobilgerät mit der Eingabeeinrichtung bedienbar ist und/oder dass das Mobilgerät Signale und insbesondere wenigstens einen Steuerbefehl an die Eingabeeinrichtung übertragen kann. Das Mobilgerät und die Eingabeeinrichtung stehen insbesondere in Wirkverbindung. Insbesondere ist eine beidseitige Kommunikation zwischen Mobilgerät und Eingabeeinrichtung vorgesehen. Insbesondere umfasst die Hülleneinrichtung wenigstens eine Kopplungseinrichtung. Die Kopplungseinrichtung kann beispielsweise eine Bluetooth-Einheit, ANT+Einheit, eine ZigBee-Einheit, eine WLAN-Einheit und/oder eine andere Datenübertragungseinheit umfassen.

In einer besonders vorteilhaften Ausgestaltung umfasst die Hülleneinrichtung wenigstens einen elektrischen Energiespeicher und beispielsweise einen Akku. Insbesondere ist die Eingabeeinrichtung durch den Energiespeicher mit elektrischer Energie versorgbar. Vorzugsweise ist der Energiespeicher an und/oder in dem Hüllenteil befestigt und vorzugsweise integriert. Möglich und vorteilhaft ist auch, dass die Eingabeeinrichtung durch einen Energiespeicher des Mobilgeräts und beispielsweise dessen Akku (auch z. B. drahtlos , induktiv...) mit Energie versorgbar ist.

Insbesondere sind wenigstens die Bremseinrichtung und/oder die Steuereinrichtung und/oder die Sensoreinrichtung derart mit Energie versorgbar. Insbesondere wird wenigstens eine Spuleneinheit bzw. Spuleneinrichtung der Bremseinrichtung über einen solchen Energiespeicher mit Strom versorgt.

Es ist möglich und vorteilhaft, dass der elektrische Energiespeicher der Hülleneinrichtung zum Aufladen des Energiespeichers des Mobilgeräts geeignet und ausgebildet ist. Insbesondere stellt die Hülleneinrichtung wenigstens einen Zusatzakku für das im Hüllenteil aufnehmbare Mobilgerät zur Verfügung.

Vorzugsweise umfasst die Hülleneinrichtung wenigstens ein Hüllenteil mit einer für Rechtshänder optimierten Anordnung der Eingabeeinrichtung. Vorzugsweise umfasst die Hülleneinrichtung (auch) wenigstens ein Hüllenteil mit einer für Linkshänder optimierten Anordnung der Eingabeeinrichtung. Insbesondere ist die Eingabeeinrichtung dabei derart angeordnet, dass diese bei der bestimmungsgemäßen Handhabung der Hülleneinrichtung entweder mit der rechten oder mit der linken Hand besser zu erreichen ist. Wenn eine Bedienung mit dem Daumen vorgesehen ist, ist die Eingabeeinrichtung für Linkshänder beispielsweise linksseitig und für Rechtshänder rechtsseitig am Hüllenteil angeordnet.

In einer besonders vorteilhaften Weiterbildung umfasst das Hüllenteil wenigstens zwei Aufnahmeeinrichtungen zur Aufnahme jeweils wenigstens einer Eingabeeinrichtung. Dabei ist die Eingabeeinrichtung vorzugsweise wahlweise in eine der Aufnahmeeinrichtungen einsetzbar. Das bietet eine besonders einfache und komfortable Anpassung an Funktionen, Apps und an die Händigkeit des Benutzers. So kann beispielsweise durch Auswahl der Aufnahmeeinrichtung eine für Rechtshänder oder für Linkshänder optimierte Anordnung der Eingabeeinrichtung erfolgen. Möglich ist es auch, dass in zwei Aufnahmeeinrichtungen jeweils eine Eingabeeinrichtung eingesetzt ist. Auch eine Nachrüstung einer Eingabeeinrichtung in eine zweite und/oder dritte oder und/oder vierte Aufnahmeeinrichtung ist möglich.

Das Hüllenteil kann auch wenigstens drei oder wenigstens vier oder mehr Aufnahmeeinrichtungen umfassen. Insbesondere umfasst die Hülleneinrichtung wenigstens eine aus dem Hüllenteil entnehmbare und wieder einsetzbare Eingabeeinrichtung. Insbesondere ist die Entnahme und/oder das Einsetzen werkzeuglos ausgestaltet. Insbesondere erfolgt durch das Einsetzen und/oder wenigstens nach dem Einsetzen in die Aufnahmeeinrichtung ein wenigstens teilweise automatisches Koppeln der Eingabeeinrichtung mit einem Energiespeicher und/oder mit dem Mobilgerät. Vorzugsweise wird durch ein Einsetzen der Eingabeeinrichtung in die Aufnahmeeinrichtung wenigstens teilweise automatisch eine elektrische Energieversorgung bereitgestellt.

Vorzugsweise umfasst das Bedienelement wenigstens zwei Betätigungszonen und besonders bevorzugt wenigstens drei oder wenigstens vier oder wenigstens fünf oder mehr Betätigungszonen. Insbesondere ist die Bewegung des Bedienelements wenigstens in Abhängigkeit davon gezielt dämpfbar, in welcher Betätigungszone das Bedienelement betätigt und insbesondere berührt wird. So können vielfältige und zugleich intuitive Bedienungsmöglichkeiten besonders kompakt und zugleich konstruktiv unaufwendig umgesetzt werden.

Insbesondere sind die Betätigungszonen nur gemeinsam bewegbar und vorzugsweise drehbar. Insbesondere sind die Betätigungszone nicht unabhängig voneinander bewegbar. Insbesondere sind die Betätigungszonen auf einer gemeinsamen Achse drehbar gelagert. Insbesondere sind die Betätigungszonen (dreh-) fest miteinander verbunden. Insbesondere ist für die Betätigungszonen wenigstens eine gemeinsame Bremseinrichtung vorgesehen. Insbesondere sind die Betätigungszonen axial direkt oder indirekt nebeneinander angeordnet. Die axiale Anordnung bezieht sich insbesondere auf eine Drehachse und/oder Längsachse des Bedienelements und/oder der Bremseinrichtung. Beispielsweise ist das Bedienelement als eine (zylindrische) Bedienwalze ausgebildet und die Betätigungszonen werden durch axiale Abschnitte eines solchen Körpers bereitgestellt.

Die Betätigungszonen sind vorzugsweise haptisch und/oder optisch (z. B. durch unterschiedliche Beleuchtung) unterscheidbar. Die Betätigungszonen können auch aus Glas, Plexiglas, transparenten oder halbtransparenten Werkstoffen sein und/oder von Innen oder Außen beleuchtet werden. Insbesondere weisen die Betätigungszonen wenigstens abschnittsweise eine unterschiedliche Oberfläche und/oder Oberflächenstruktur und/oder Geometrie und/oder Farbe und/oder Material und/oder Größe auf. Beispielsweise unterscheiden sich die Betätigungszonen in ihrer Rauigkeit und/oder in ihrem Durchmesser und/oder in ihrer Außenkontur. Beispielsweise unterscheiden sich die Betätigungszonen in ihrer Farbe und/oder Beleuchtung.

Möglich und vorteilhaft ist, dass wenigstens eine (bestimmte) haptische Rückmeldung in Abhängigkeit davon erfolgt, in welcher Betätigungszone das Bedienelement betätigt und insbesondere berührt wird. Insbesondere ist die Steuereinrichtung dazu geeignet und ausgebildet, ein haptisches Signal in Abhängigkeit davon umzusetzen, an welcher der Betätigungszonen eine Betätigung bzw. Berührung erfolgt. Beispielsweise wird je nach betätigter Betätigungszone eine andere Abfolge von Verzögerungsmomenten und beispielsweise unterschiedliche Rippel eingestellt. (Rippel = (stark) alternierendes Drehmoment (nieder/hoch) in zeitlichen oder winkelabhängigen Abständen). Es kann auch vorgesehen sein, dass für die Betätigungszonen unterschiedlich viele Rasterpunkte bzw. Anschläge eingestellt werden.

Die Betätigungszonen sind vorzugsweise zur Bedienung jeweils wenigstens einer bestimmten Funktion des Mobilgeräts geeignet und ausgebildet, sodass insbesondere je nach betätigter Betätigungszone eine andere Funktion des Mobilgeräts ansteuerbar ist. Insbesondere ist den Betätigungszonen jeweils wenigstens eine Gerätefunktion zugeordnet. Insbesondere kann durch Auswahl der Betätigungszone jeweils wenigstens eine andere Gerätefunktion bedient werden. Beispielsweise können so über nur ein einziges Bedienelement drei verschiedene Gerätefunktionen intuitiv und komfortabel angesteuert werden.

Es ist ebenfalls bevorzugt und vorteilhaft, dass die Betätigungszonen jeweils durch eine Berührung und/oder ein Drücken aktivierbar und insbesondere auch deaktivierbar sind. Beispielsweise wird eine Drehbewegung des Bedienelementes derjenigen Betätigungszone zugeordnet, welche zuvor wenigstens einmal berührt und/oder gedrückt wurde. Es ist möglich, dass dazu eine Erfassung, insbesondere eine Messung, einer Druckintensität erfolgt. Insbesondere sind die Betätigungszonen in Abhängigkeit der Druckintensität aktivierbar. Insbesondere ist den Betätigungszonen jeweils wenigstens ein Drucksensor zugeordnet.

Es ist in allen Ausführungen der Erfindung möglich, dass auch eine Druckintensität auf das Bedienelement und insbesondere auf eine bestimmte Betätigungszone erfasst wird und für die Eingabe berücksichtigt wird. Beispielsweise erfolgt bei einem nur leichten Drücken, dass eine Eingabe beginnt bzw. eine Funktion ausgewählt und/oder gestartet wird. Ein stärkeres Drücken kann beispielsweise zur Bestätigung bzw. zur Ausführung eines Befehls vorgesehen sein. Insbesondere verändert sich die haptische Rückmeldung abhängig von der gewählten Funktion. Das hat den Vorteil, dass der Nutzer erkennen kann, was er gewählt hat und was er einstellt.

In einer vorteilhaften Weiterbildung ist das Bedienelement als eine Wippe ausgebildet. Insbesondere umfasst das Bedienelement wenigstens ein Wipplager. Insbesondere ist das Wipplager zwischen wenigstens zwei Betätigungszonen angeordnet. Insbesondere kann das Bedienelement zur Durchführung einer Eingabe zu beiden Seiten des Wipplagers gekippt werden. Insbesondere erfolgt je nach gedrückter und/oder gezogener Betätigungszone eine bestimmte Eingabe und/oder eine bestimmte haptische Rückmeldung. Dabei kann für das Drücken und/oder Ziehen eine Dämpfung mittels der Bremseinrichtung vorgesehen sein oder nicht. Insbesondere weist das Wipplager eine Schwenkachse auf, welche quer zur Drehachse des Bedienelements angeordnet ist.

Insbesondere umfasst die Hülleneinrichtung wenigstens eine Überwachungseinrichtung. Insbesondere die Überwachungseinrichtung dazu geeignet und ausgebildet, sensorisch zu erfassen, in welcher Betätigungszone eine Betätigung erfolgt. Die Überwachungseinrichtung umfasst insbesondere wenigstens einen Bilderkennungs- und/oder Näherungssensor und/oder wenigstens einen Berührungssensor und/oder Radarsensor und/oder wenigstens eine Kameraeinrichtung und/oder wenigstens einen kapazitiven Sensor. Insbesondere ist den Betätigungszonen jeweils wenigstens ein Sensor der Überwachungseinrichtung zugeordnet.

In einer besonders vorteilhaften Weiterbildung ist durch wenigstens eine erste Bewegung des Bedienelements eine erste Eingabe ausführbar. Insbesondere ist durch ein Weiterbewegen des Bedienelement wenigstens eine weitere Eingabe ausführbar. Insbesondere ist für die erste Bewegung eine andere Dämpfung als für das Weiterbewegen vorgesehen. Vorzugsweise erfolgt nach der ersten Bewegung wenigstens eine gezielte Erhöhung des Verzögerungsmoments, sodass zum Weiterbewegen ein zusätzlicher Kraftaufwand notwendig ist.

Die erste Bewegung umfasst insbesondere eine Drehung um einen definierten Drehwinkel. Insbesondere ist eine vorübergehende Erhöhung des Verzögerungsmomentes vorgesehen. Insbesondere muss ein bestimmter Winkelbereich überwunden werden, um danach wieder leichter weiter drehen zu können. Die vorübergehende Erhöhung kann eine definierte Zeit und/oder einen definierten Winkelbereich umfassen. Möglich ist, dass das Verzögerungsmoment dauerhaft erhöht oder verringert wird. Das erhöhte bzw. verringerte Verzögerungssummen kann über die Zeit und/oder den Winkel weiter ansteigen bzw. nachlassen. Der Begriff dauerhaft bezieht sich hier insbesondere auf die Dauer einer ausgeführten Bedienung. Das Weiterbewegen umfasst insbesondere eine Drehung um einen definierten Drehwinkel.

Vorzugsweise wird durch die erste Bewegung des Bedienelements wenigstens eine Funktion gestartet. Vorzugsweise erfolgt durch das Weiterbewegen des Bedienelements wenigstens eine Anpassung der Funktion. Durch das Weiterbewegen kann auch wenigstens eine weitere Funktion gestartet werden. Beispielsweise wird durch die erste Bewegung das Abspielen von Medien oder das Annehmen eines Anrufs oder das Starten einer Kamerafunktion ausgeführt. Durch das Weiterbewegen erfolgt dann beispielsweise eine Regulierung der Lautstärke der Wiedergabe bzw. des Anrufs oder ein Auslösen der Kamera oder eine Auswahl der Aufnahmeart.

Vorzugsweise ist die Steuereinrichtung dazu geeignet und ausgebildet, wenigstens ein an dem Bedienelement wahrnehmbares haptisches Signal bereitzustellen, welches als Hilfestellung für Menschen mit einer Beeinträchtigung dient. Beispielsweise wird dazu ein Morsecode aus Verzögerungsmomenten erzeugt. Möglich ist auch, dass ein anderer geeigneter Code aus Verzögerungsmomenten erzeugt wird. Beispielsweise werden für einen solchen Code höhere und geringere Verzögerungsmomente in eine gezielte Abfolge gesetzt. Die Hilfestellung ist insbesondere für Menschen mit Sehschwäche und/oder mit einer Hörschwäche vorgesehen. Es ist möglich, dass das Signal durch eine Betätigung des Bedienelements gestartet und/oder wiederholt werden kann. Beispielsweise wird das Signal durch einmaliges Drücken oder Drehen gestartet. Durch Weiterdrehen des Bedienelements kann das Signal dann haptisch wahrgenommen werden, beispielsweise mit dem Finger oder Daumen. Beispielsweise beschreibt das Signal eine aktuell ausgewählte Funktion des Mobilgeräts oder den Akkuzustand oder eine ausgewählte Telefonnummer oder sonstige Funktionen, bei denen üblicherweise Informationen visuell erfasst werden müssen.

Es ist möglich und vorteilhaft, dass durch wenigstens ein Bewegen, insbesondere Drehen, des Bedienelements ein Zoomen und/oder Scrollen und/oder eine Kameraauswahl und/oder eine Anrufsteuerung, beispielsweise Anrufannahme und/oder Anrufbeendigung, und/oder eine Menüauswahl ausführbar ist. Vorzugsweise sind durch das Bewegen des Bedienelements auch andere Funktionen ausführbar. Besonders bevorzugt sind durch das Drehen des Bedienelements Funktionen ausführbar, welche sonst durch ein Drehen eines auf dem Bildschirm simulierten Rades bzw. Drehbalkens bedient werden. So kann beispielsweise durch das Drehen des Bedienelements das Stellen eines Weckers oder eine Datumsauswahl im Kalender erfolgen.

Es ist vorteilhaft und bevorzugt, dass durch wenigstens ein Bewegen, insbesondere Drehen, des Bedienelements wenigstens eine Hervorhebung, beispielsweise eine Vergrößerung, eines Anzeigebereichs gezielt weiter geschoben werden kann und vorzugsweise weiterspringt. Vorzugsweise springt die Hervorhebung des Anzeigebereichs in Leserichtung von einem Textteil, beispielsweise einer Zeile, zum nachfolgenden Textteil, beispielsweise der nächsten Zeile. Vorzugsweise ist die Hervorhebung durch wenigstens ein Drücken und/oder wenigstens ein Drehen des Bedienelements aktivierbar. Eine solche Ausgestaltung ermöglicht ein sogenanntes intelligentes Lesen.

Es ist möglich und vorteilhaft, dass das Hüllenteil klappbar ausgebildet ist. Dazu umfasst das Hüllenteil wenigstens zwei Hüllenabschnitte. Die Hüllenabschnitte sind durch wenigstens eine Scharniereinrichtung bewegbar miteinander verbunden. Vorzugsweise ist die Eingabeeinrichtung in die Scharniereinrichtung integriert. Insbesondere ist dabei wenigstens ein Hüllenabschnitt zur Aufnahme des Mobilgerätes ausgebildet. Das bietet eine sichere Unterbringung des Mobilgeräts. Zudem ist eine solche Ausführung besonders kompakt, da Eingabeeinrichtung und Scharniereinrichtung sich den Bauraum teilen.

Insbesondere ist wenigstens im aufgeklappten Zustand eine Bedienung über die Eingabeeinrichtung vorgesehen. Vorzugsweise ist auch im zugeklappten Zustand eine Bedienung über die Eingabeeinrichtung vorgesehen. So kann das Mobilgerät mit zugeklappten Hüllenteil in der Jackentasche getragen werden und eine Lautstärkeregelung z. B. der Kopfhörer erfolgt über die Eingabeeinrichtung. Es ist möglich, dass die Eingabeeinrichtung automatisch aktiviert wird, sobald das Hüllenteil aufgeklappt wird.

Die Eingabeeinrichtung bzw. die Bremseinrichtung umfasst insbesondere eine Drehachse, um welche das Bedienelement drehbar ist. Insbesondere umfasst die Scharniereinrichtung eine Drehachse, um welche die Hüllenabschnitte schwenkbar sind. Vorzugsweise entspricht die Drehachse der Eingabeeinrichtung dabei der Drehachse der Scharniereinrichtung oder ist parallel zu dieser. Insbesondere ist das Bedienelement um die Drehachse der Scharniereinrichtung drehbar.

Vorzugsweise ist die Steuereinrichtung dazu geeignet und ausgebildet, sensorisch zu erkennen, ob eine Bewegung des Bedienelements durch eine Betätigung oder durch ein Klappen der Scharniereinrichtung bedingt ist. Dazu ist z. B. die Überwachungseinrichtung vorgesehen.

Vorzugsweise ist eine Bewegbarkeit der Scharniereinrichtung wenigstens teilweise mittels der Bremseinrichtung gezielt dämpfbar. Insbesondere ist die Scharniereinrichtung in wenigstens einer Schwenkstellung fixierbar. Vorzugsweise ist die Scharniereinrichtung im aufgeklappten Zustand und/oder im zusammengeklapptem Zustand des Hüllenteils blockierbar und/oder fixierbar. Unter einer Fixierung wird insbesondere verstanden, dass das Verzögerungsmoment derart hoch ist, dass erst durch einen erhöhten Kraftaufwand ein Weiterbewegen der Scharniereinrichtung möglich ist.

Die Bewegbarkeit der Scharniereinrichtung kann mit der Bremseinrichtung auch gezielt blockierbar sein. Unter einer Blockierung wird insbesondere ein derart hohes Verzögerungsmoment verstanden, dass mit den bestimmungsgemäß zu erwartenden Handkräften keine Bewegung der Scharniereinrichtung möglich ist. Insbesondere muss dann erst eine andere Betätigung des Bedienelements erfolgen, um die Blockierung aufzuheben.

Vorzugsweise ist mittels wenigstens einer Benutzereinstellung eine Vorgabe möglich, an welcher Position die Scharniereinrichtung fixiert und/oder blockiert wird. Dadurch kann der Benutzer das Hüllenteil in einer bestimmten Position fixieren, sodass er beispielsweise besser lesen oder Videos schauen kann. Vorzugsweise können durch wenigstens eine Benutzereinstellung zwei oder mehr Rasterpunkte eingestellt werden. Einem Rasterpunkt sind dabei eine bestimmte Schwenkstellung bzw. ein bestimmter Drehwinkel zugeordnet und ein bestimmtes Verzögerungsmoment zugeordnet. Wird z. B. ein aufgeklapptes Smartdevice für die Videotelefonie benutzt, so kann ein Winkel eingestellt und fixiert werden. Ein solcher Rasterpunkt muss insbesondere durch einen erhöhten Kraftaufwand überwunden werden. An einem solchen Rasterpunkt kann auch eine Blockierung der Bewegbarkeit vorgesehen sein. Damit kann auch das aufgeklappte Display während z.B. der Videotelefonie bedient werden, ohne dass es aufgrund der Touchkraft wegklappt.

Möglich ist auch, dass die Bewegbarkeit der Scharniereinrichtung mittels einer entsprechend hochfrequenten Abfolge von unterschiedlichen Verzögerungsmomenten gedämpft wird. Dadurch ist beispielsweise ein Vibrieren oder Zittern beim Aufklappen oder Zuklappen des Hüllenteils möglich.

Eine weitere erfindungsgemäße Hülleneinrichtung ist für ein Mobilgerät und besonders bevorzugt für ein klappbares Mobilgerät vorgesehen. Beispielsweise ist die Hülleneinrichtung für ein klappbares Smartphone oder klappbares Tablet oder eine andere Art eines klappbaren Handhelds bzw. mobilen Smart Devices vorgesehen. Die Hülleneinrichtung umfasst wenigstens ein Hüllenteil zum wenigstens abschnittsweisen Umgeben des Mobilgeräts. Das Hüllenteil ist klappbar ausgebildet. Dazu umfasst das Hüllenteil wenigstens zwei Hüllenabschnitte, welche durch wenigstens eine Scharniereinrichtung bewegbar verbunden sind. Dabei umfasst die Scharniereinrichtung wenigstens eine Bremseinrichtung. Die Bremseinrichtung ist dazu geeignet und ausgebildet, die Bewegung der Hüllenabschnitte zueinander gezielt zu dämpfen.

Auch diese Hülleneinrichtung löst die Aufgabe besonders vorteilhaft. Durch die gezielte Dämpfung der Hüllenabschnitte kann die Bedienung eines in dem Hüllenteil aufnehmbaren Mobilgeräts erheblich verbessert und komfortabler gestaltet werden. Die Hülleneinrichtung und/oder Scharniereinrichtung und/oder Bremseinrichtung sind insbesondere wenigstens teilweise so ausgebildet, wie es im Rahmen der zuvor vorgestellten Hülleneinrichtung beschrieben wurde.

Besonders bevorzugt ist die Bremseinrichtung magnetorheologisch ausgebildet und/oder umfasst wenigstens eine magnetorheologische Bremseinrichtung und kann ausgestaltet und weitergebildet sein, wie zuvor beschrieben.

Vorzugsweise steht die Scharniereinrichtung und/oder die Bremseinrichtung an nur einer Seite oder an keiner Seite des zusammengeklapptem Hüllenteils über dessen Breite und/oder Höhe und/oder Länge hinaus. Die Scharniereinrichtung und/oder die Bremseinrichtung können auch an nur zwei Seiten oder nur drei Seiten derart hinaus stehen. Vorzugsweise weist die Scharniereinrichtung und/oder die Bremseinrichtung einen maximalen Durchmesser und/oder eine maximale Höhe und/oder Breite auf, welcher bzw. welche gleich oder kleiner als eine Stärke (Dicke) des zusammengeklapptem Hüllenteils ist. Das ermöglicht eine besonders kompakte und gut zu transportieren Hülleneinrichtung. Die Scharniereinrichtung kann wenigstens abschnittsweise über einen Umfang des Hüllenteils hervorstehen. Die Scharniereinrichtung kann innerhalb eines Umfangs des Hüllenteils angeordnet sein.

Insbesondere ist eine Bewegung der Hüllenabschnitte mit einem gezielten Verzögerungsmoment beaufschlagbar, sodass die Hüllenabschnitte im geschlossenen und/oder im geöffneten Zustand und/oder in einem beliebigen Öffnungswinkel fixierbar und/oder blockierbar sind. Vorzugsweise ist der Scharniereinrichtung wenigstens eine Steuereinrichtung zugeordnet, mittels welcher die Bremseinrichtung ansteuerbar ist, um eine gezielte Dämpfung für die Bewegung der Hüllenabschnitte einzustellen. Insbesondere ist die Steuereinrichtung dazu geeignet und ausgebildet, die Funktionen auszuführen, welche im Rahmen der zuvor vorgestellten Hülleneinrichtung beschrieben wurde.

Insbesondere ist die magnetorheologische Bremseinrichtung in die Scharniereinrichtung integriert. Insbesondere entspricht die Drehachse der Bremseinrichtung der Drehachse der Scharniereinrichtung und/oder ist parallel zu dieser. Die Drehachsen können auch identisch sein. Insbesondere sind die Drehachsen auf einer gemeinsamen Geraden angeordnet.

Das erfindungsgemäße Mobilgerät ist insbesondere ein Smartphone oder ein Tablet oder eine andere Art von Handheld bzw. mobilen Smart Devices. Das Mobilgerät umfasst wenigstens einen Gerätekörper. Das Mobilgerät umfasst wenigstens eine Eingabeeinrichtung zur Ansteuerung von Gerätefunktionen. Dabei umfasst die Eingabeeinrichtung wenigstens ein bewegbares Bedienelement und wenigstens eine Bremseinrichtung. Dabei ist wenigstens eine Bewegung des Bedienelement mittels der Bremseinrichtung gezielt dämpfbar. Vorzugsweise ist die Eingabeeinrichtung zu einem überwiegenden Teil innerhalb des Gerätekörpers angeordnet.

Ein solches Mobilgerät löst die zuvor gestellte Aufgabe besonders vorteilhaft. Es bietet neben einer erheblich komfortableren Bedienung auch eine besonders kompakte Bauweise.

Besonders bevorzugt ist die Bremseinrichtung magnetorheologisch ausgebildet und/oder umfasst wenigstens eine magnetorheologische Bremseinrichtung. Eine oder die magnetorheologische Bremseinrichtung umfasst wenigstens ein magnetorheologisches Medium und wenigstens eine Felderzeugungseinrichtung zur Erzeugung und Steuerung einer magnetischen und/oder elektrischen Feldstärke. Mittels der bzw. einer Felderzeugungseinrichtung ist das rheologische (insbesondere das magnetorheologische) Medium vorzugsweise beeinflussbar, um das Drehmoment für die Drehbarkeit des Bedienelements einzustellen. Eine magnetorheologische Bremseinrichtung bietet besonders viele Vorteile.

Unter eine Anordnung innerhalb des Gerätekörpers wird erfindungsgemäß verstanden, dass etwas innerhalb eines von dem Gerätekörper wenigstens teilweise umgrenzten Raumes aufgenommen ist. Vorzugsweise ist die Eingabeeinrichtung zu mehr als 50 % und vorzugsweise zu mehr als 65 % und besonders bevorzugt zu mehr als 75 % innerhalb des Gerätekörpers angeordnet. Insbesondere ragt nur ein Teil des Bedienelements aus dem Gerätekörper hervor. Vorzugsweise ist das Bedienelement in Bezug auf seine Querschnittsfläche zu einem überwiegenden Teil und insbesondere zu wenigstens 50 % innerhalb des Gerätekörpers angeordnet.

Bevorzugt ist, dass das Bedienelement um wenigstens eine Drehachse drehbar ist. Vorzugsweise ist die Drehachse dabei innerhalb des Gerätekörpers angeordnet. Insbesondere steht die Drehachse nicht aus dem Gerätekörper hervor. Insbesondere weist das Bedienelement einen Umfang auf, welcher zu mehr als der Hälfte in Gerätekörper angeordnet ist. Besonders bevorzugt ist, dass ein Durchmesser des Bedienelements, insbesondere einer Bedienwalze, geringer als eine minimale Stärke des Gerätekörpers ist.

Vorzugsweise ist die Eingabeeinrichtung des Mobilgeräts wenigstens teilweise wie die im Rahmen der Hülleneinrichtung beschriebene Eingabeeinrichtung ausgebildet.

In einer vorteilhaften Weiterbildung des Mobilgeräts umfasst das Bedienelement wenigstens zwei Betätigungszonen. Insbesondere ist eine Bewegung des Bedienelements in Abhängigkeit davon gezielt dämpfbar, in welcher Betätigungszone das Bedienelement betätigt und insbesondere berührt wird.

Ein weiteres erfindungsgemäßes Mobilgerät ist insbesondere als Smartphone oder Tablet oder eine andere Art von Handheld bzw. mobilen Smart Device ausgebildet. Das Mobilgerät ist wenigstens teilweise klappbar ausgebildet. Dazu umfasst das Mobilgerät, insbesondere dessen Gerätekörper, wenigstens zwei Geräteteile. Die Geräteteile sind durch wenigstens eine Scharniereinrichtung bewegbar verbunden. Dabei ist die Scharniereinrichtung mit wenigstens einer magnetorheologischen Bremseinrichtung ausgestattet. Die magnetorheologische Bremseinrichtung ist dazu geeignet und ausgebildet, die Bewegung der Geräteteile zueinander gezielt zu dämpfen.

Auch ein solches Mobilgerät löst die zuvor gestellte Aufgabe besonders vorteilhaft. Dieses erfindungsgemäße Mobilgerät kann mit einer Eingabeeinrichtung ausgestattet sein. Insbesondere sind die Eingabeeinrichtung und/oder Bremseinrichtung und/oder die Scharniereinrichtung wie zuvor für das andere Mobilgerät und/oder die Hülleneinrichtung beschrieben ausgebildet.

Insbesondere ist die Eingabeeinrichtung in die Scharniereinrichtung integriert. Insbesondere ist eine Drehachse der Eingabeeinrichtung entlang einer Drehachse der Scharniereinrichtung angeordnet oder verläuft parallel zu dieser. Diese Drehachsen können auch identisch sein. Insbesondere sind die Drehachsen auf einer gemeinsamen Geraden angeordnet.

Insbesondere ist die Bremseinrichtung in die Scharniereinrichtung integriert. Insbesondere weist die Scharniereinrichtung des Mobilgeräts wenigstens eine Drehachse auf, um welche die Geräteteile schwenkbar sind. Insbesondere verläuft die Drehachse entlang einer Drehachse der magnetorheologischen Bremseinrichtung oder ist parallel zu dieser. Die Drehachsen können auch identisch sein. Insbesondere sind die Drehachsen auf einer gemeinsamen Geraden angeordnet.

Vorzugsweise steht die Scharniereinrichtung und/oder die Bremseinrichtung an nur einer Seite oder an keiner Seite des zusammengeklappten Gerätekörpers über dessen Breite und/oder Höhe und/oder Länge hinaus. Die Scharniereinrichtung und/oder die Bremseinrichtung können auch an nur zwei Seiten oder nur drei Seiten derart hinaus stehen. Vorzugsweise weist die Scharniereinrichtung und/oder die Bremseinrichtung einen maximalen Durchmesser und/oder eine maximale Höhe und/oder Breite auf, welcher bzw. welche gleich oder kleiner als eine Stärke (Dicke) des zusammengeklappten Gerätekörpers ist. Die Scharniereinrichtung kann wenigstens abschnittsweise über einen Umfang des Gerätekörpers hinaus stehen. Die Scharniereinrichtung kann innerhalb eines Umfangs des Gerätekörpers angeordnet sein.

Die Anmelderin behält sich vor, eine Buchstütze insbesondere für ein Mobilgerät zu beanspruchen, welche wenigstens teilweise klappbar ausgebildet ist und welche wenigstens zwei Stützabschnitte umfasst. Die Stützabschnitte sind durch wenigstens eine Scharniereinrichtung bewegbar verbunden. Dabei umfasst die Scharniereinrichtung wenigstens eine magnetorheologische Bremseinrichtung, welche dazu geeignet und ausgebildet ist, die Bewegung der Stützabschnitte zueinander gezielt zu dämpfen. Insbesondere sind die Bremseinrichtung und/oder die Scharniereinrichtung wie zuvor für das Mobilgerät und/oder die Hülleneinrichtung beschrieben ausgebildet. Dabei kann in die Scharniereinrichtung der Buchstütze auch eine Eingabeeinrichtung integriert sein, wie sie zuvor beschrieben wurde.

Die erfindungsgemäße Eingabeeinrichtung ist für eine der zuvor beschriebenen Hülleneinrichtungen und/oder für eines der zuvor beschriebenen Mobilgeräte geeignet und ausgebildet.

Das erfindungsgemäße Verfahren dient zum Betreiben einer der zuvor beschriebenen Hülleneinrichtungen und/oder eines der zuvor beschriebenen Mobilgeräte.

Es möglich, dass die Eingabeeinrichtung wenigstens teilweise an und/oder in einem Tragteil angeordnet ist. Das Tragteil ist insbesondere mit dem Mobilgerät und insbesondere dessen Gerätekörper verbindbar bzw. verbunden. Insbesondere ist das Tragteil wenigstens teilweise und vorzugsweise vollständig innerhalb des Gerätekörpers angeordnet.

Vorzugsweise ist die Eingabeeinrichtung mit dem Mobilgerät koppelbar und insbesondere gekoppelt. Insbesondere ist die Eingabeeinrichtung, vorzugsweise wenigstens die Bremseinrichtung und/oder die Steuereinrichtung und/oder die Sensoreinrichtung, durch wenigstens einen Energiespeicher des Mobilgeräts mit Energie versorgbar. Insbesondere stehen die Eingabeeinrichtung und das Mobilgerät in Wirkverbindung.

Vorzugsweise sind für die Hülleneinrichtung und/oder für das Mobilgerät wenigstens zwei Scharniereinrichtungen vorgesehen, deren Drehachsen insbesondere auf einer gemeinsamen Geraden angeordnet. Dabei kann nur ein Teil der Scharniereinrichtungen eine Eingabeeinrichtung aufweisen.

Möglich ist auch, dass die Eingabeeinrichtung separat zu der Scharniereinrichtung vorgesehen ist. Dabei kann vorgesehen sein, dass die Drehachsen der Scharniereinrichtung und der Eingabeeinrichtung auf einer gemeinsamen geraden liegen oder parallel zueinander angeordnet sind oder auch quer zueinander verlaufen.

Die Eingabeeinrichtung kann fest mit dem Hüllenteil verbunden sein. Die Eingabeeinrichtung kann auch lösbar und insbesondere Werkzeug frei lösbar mit dem Hüllenteil verbunden sein. Insbesondere ist die Eingabeeinrichtung in das Hüllenteil integriert.

Insbesondere ist das Bedienelement drehbar ausgebildet. Insbesondere ist das Bedienelement gegenüber einer Achse oder einer anderen Tragstruktur drehbar gelagert. Eine solche Tragstruktur kann insbesondere durch eine erste oder zweite Bremskomponente einer Bremseinrichtung bereit gestellt werden.

Das Hüllenteil kann beispielsweise schalenartig ausgebildet sein. Beispielsweise umgreift das Hüllenteil das Mobilgerät schalenartig. Das Hüllenteil kann zum Einstecken des Mobilgeräts ausgebildet sein. Insbesondere ist ein schalenartiges Hüllenteil vorgesehen. Möglich sind auch andere Ausformungen.

Die Eingabeeinrichtung ist insbesondere seitlich an dem Hüllenteil angeordnet. Die Eingabeeinrichtung ist insbesondere an einer Seite angeordnet, welche sich zwischen einer Vorderseite und einer Rückseite des Hüllenteils erstreckt. Insbesondere ist die Eingabeeinrichtung seitlich links oder rechts oder oben oder unten angeordnet. Es können auch zwei oder mehr Eingabeeinrichtungen an einer oder mehrerer Seiten angeordnet sein. Möglich ist auch eine Anordnung der Eingabeeinrichtung an einer Vorderseite und/oder Rückseite des Hüllenteils.

Die Steuereinrichtung ist insbesondere dazu geeignet und ausgebildet, in Abhängigkeit des Steuerbefehls eine Drehbewegung des Bedienelements in eine und/oder beide Drehrichtungen und/oder über einen bestimmten Drehwinkel und/oder bei einer bestimmten Drehgeschwindigkeit und/oder bei einer bestimmten Betätigungskraft mit wenigstens einem bestimmten Verzögerungsmoment zu beaufschlagen. Dadurch kann die Drehbewegung gezielt verzögert und/oder blockiert und/oder freigegeben werden.

Insbesondere ist die Steuereinrichtung dazu geeignet und ausgebildet, in Abhängigkeit des Steuerbefehls eine Drehbewegung des Bedienelements über die Zeit und/oder über den Drehwinkel veränderlich und/oder stetig zu dämpfen.

In allen Ausgestaltungen ist es besonders bevorzugt, dass das Bedienelement zur Ansteuerung des Mobilgeräts wenigstens drehbar ausgebildet ist. Insbesondere ist wenigstens die Drehbewegung des Bedienelement mittels der magnetorheologischen Bremseinrichtung gezielt dämpfbar.

Es ist bevorzugt und vorteilhaft, dass das Bedienelement zur Ansteuerung des Mobilgeräts zusätzlich zu einer Drehbarkeit auch gedrückt und/oder gezogen werden kann. Vorzugsweise ist dann die Drehbewegung mittels der Bremseinrichtung gezielt dämpfbar. Das Drücken und/oder Ziehen ist dann vorzugsweise ohne gezielte Dämpfung ausgebildet.

Es ist möglich, dass das Bedienelement zu Ansteuerung des Mobilgeräts wenigstens linear (also entlang seiner Längsachse) bewegbar und insbesondere drückbar bzw. schiebbar und/oder ziehbar ist. Insbesondere stellt das Bedienelement in einer solchen Ausführung wenigstens eine Drucktaste zur Verfügung. Dann ist insbesondere wenigstens die lineare Bewegung des Bedienelements mittels der magnetorheologischen Bremseinrichtung gezielt dämpfbar.

Möglich ist auch, dass das Bedienelement zu Ansteuerung des Mobilgeräts zusätzlich zu einer linearen Bewegbarkeit auch gedreht werden kann. Dann ist insbesondere die lineare Bewegbarkeit mittels der Bremseinrichtung gezielt dämpfbar. Die Drehbewegung ist dann insbesondere ohne gezielte Dämpfung ausgebildet.

Es ist besonders bevorzugt, dass das Bedienelement wenigstens eine Bedienwalze und vorzugsweise wenigstens eine Fingerwalze umfasst oder als eine solche ausgebildet ist. Unter einer Fingerwalze wird insbesondere auch eine Daumenwalze verstanden. Die Bedienwalze ist insbesondere um eine Drehachse drehbar, um eine Eingabe vorzunehmen. Die Bedienwalze kann insbesondere quer zu ihrer Drehachse gedrückt und/oder gezogen werden, um eine Eingabe vorzunehmen. Während des Drückens (Push) kann das Drehen des Bedienelements (insbesondere der Bedienwalze und/oder eines Drehknopfs) unterbunden werden, was das Drücken angenehmer und sicherer macht, weil beim Drücken der z. B. Bedienwalze diese nicht ungewollt rotiert wird (Erhöhtes Drehmoment oder Blockieren der Bedienwalzenrotation bei Push).

Das Bedienelement kann auch wenigstens einen Drehknopf und/oder wenigstens einen Drucktaster umfassen oder derart ausgebildet sein. Der Drehknopf ist insbesondere um eine Drehachse drehbar, um eine Eingabe vorzunehmen. Der Drehknopf kann insbesondere in Richtung seiner Längsachse bzw. Drehachse gedrückt und/oder gezogen werden, um eine Eingabe vorzunehmen. Möglich ist auch, dass der Drehknopf quer zu seiner Drehachse gedrückt und/oder gezogen werden kann. Der Drucktaster wird insbesondere entlang einer linearen Bewegungsachse bewegt, um eine Eingabe vorzunehmen. Der Drucktaster kann insbesondere um eine lineare Bewegungsachse gedreht werden, um eine Eingabe vorzunehmen.

In allen Ausgestaltungen ist es besonders bevorzugt, dass die Eingabeeinrichtung derart dimensioniert ist, dass eine Unterbringung in einem Bauraum von maximal 12 mm und besonders bevorzugt maximal 10 mm Höhe und/oder Breite und/oder Durchmesser umsetzbar ist. Insbesondere ist ein Bedienelement, vorzugsweise eine Bedienwalze, vorgesehen, welches einen Durchmesser von maximal 12 mm und vorzugsweise maximal 10 mm aufweist. Mit der im Rahmen der vorliegenden Erfindung vorgestellten magnetorheologischen Bremseinrichtung sind solche Anforderungen besonders vorteilhaft umsetzbar.

Insbesondere ist die Bremseinrichtung mittels der Steuereinrichtung ansteuerbar, um wenigstens einen der genannten Verfahrensschritte bzw. Funktionen bzw. Funktionsweisen umzusetzen. Vorzugsweise können die genannten Verfahrensschritt bzw. Funktionen bzw. Funktionsweisen auch in Kombination miteinander umgesetzt werden.

In vorteilhaften Ausgestaltungen ist es bevorzugt, dass die Sensoreinrichtung ein Sensormittel mit wenigstens einem Sensor umfasst (z. B. Encoder, Drehgeber, Hallgeber...). Der Sensor ist z. B. ein Winkelsensor und insbesondere Drehwinkelsensor. Es kann eine absolute Stellung (z. B. Absolutwertgeber) oder eine relative Stellung erfassbar sein. Das Sensormittel kann unmittelbar oder auch indirekt über eine Stellung eines anderen Bauteils und insbesondere der Bremseinrichtung den Winkel des Bedienelements erfassen. Beispielsweise wird dazu eine Winkelstellung und/oder ein Drehwinkel der Bremseinrichtung erfasst. Der erfasste Winkel wird vorzugsweise der Steuereinrichtung für die Ansteuerung der Bremseinrichtung bereitgestellt.

Das Halte-/Verzögerungsmoment so hoch eingestellt werden, dass mit einem erhöhten Kraftaufwand ein Weiterbewegen des Bedienelements möglich ist. Das Verzögerungsmoment kann aber auch so hoch eingestellt werden, dass das Bedienelement bei den betriebsgemäßen Handkräften blockiert ist. Das Weiterbewegen des Bedienelements mit erhöhtem Kraftaufwand und/oder das Blockieren des Bedienelements können dabei in wenigstens eine oder auch beide Drehrichtungen erfolgen.

Der Steuerbefehl kann unabhängig von einer Eingabe und/oder als Rückmeldung (Feedback) auf eine mit dem Mobilgerät oder der Eingabeeinrichtung vorgenommene Eingabe erfolgen. Insbesondere wird in Abhängigkeit des Steuerbefehls das Verzögerungsmoment angepasst. Der Steuerbefehl kann wenigstens eine reale Betriebssituation und/oder wenigstens eine mittels einer Software simulierte Situation betreffen.

Insbesondere ist die Steuereinrichtung dazu geeignet und ausgebildet, den Steuerbefehl zu empfangen und dann wenigstens unter Berücksichtigung des Steuerbefehls das Verzögerungsmoment anzupassen. Insbesondere ist die Steuereinrichtung dazu geeignet und ausgebildet, die zuvor und/oder nachfolgend beschriebenen Ansteuerungen der Bremseinrichtung auch wenigstens teilweise in Abhängigkeit des Steuerbefehls vorzunehmen.

Vorzugsweise ist die Steuereinrichtung dazu geeignet und ausgebildet, den Steuerbefehl in wenigstens ein an dem Bedienelement wahrnehmbares haptisches Signal (Kraft-/Momentenänderung) umzusetzen, insbesondere sodass der Benutzer als Folge einer vorgenommenen Eingabe eine haptische Rückmeldung (z.B. erhöhte Kraft an der Mensch-Maschinenschnittstelle) erhalten kann.

Insbesondere kann das Mobilgerät die Bewegbarkeit bzw. Dämpfung des Bedienelements gezielt beeinflussen. Dadurch sind haptische Rückmeldungen (wie z. B. Force-Feedback) besonders vorteilhaft umsetzbar. Das haptische Signal umfasst vorzugsweise wenigstens eine definierte Abfolge von Verzögerungsmomenten. Das haptische Signal umfasst besonders bevorzugt wenigstens eine definierte Abfolge von sich (schnell) ändernden Verzögerungsmomenten bzw. Kräften an der Mensch-/Maschinenschnittstelle (auch Rippel/Ticks/Raster genannt).

Das individuelle Feedback kann von der Software in Form von künstlicher Intelligenz zugeordnet werden.

Insbesondere ist eine beliebige Anzahl von mit der Bremseinrichtung umsetzbaren Rastpositionen an beliebigen Positionen im betriebsgemäßen Bewegungs- bzw. Drehbereich des Bedienelements einstellbar. Insbesondere sind die Rastpositionen in Abhängigkeit des Drehwinkels und/oder der Zeit und/oder des Steuerbefehls einstellbar. Insbesondere sind die Rastpositionen wenigstens durch einen Drehwinkel und ein Verzögerungsmoment definiert.

Die Steuereinrichtung ist insbesondere dazu geeignet und ausgebildet, das Verzögerungsmoment bereits ab einem definierten Drehwinkel vor Erreichen einer Rastposition zu erhöhen und/oder ab einem definierten Drehwinkel nach Verlassen der Rastposition zu verringern.

Das Erhöhen und/oder Verringern des Verzögerungsmoments kann in allen Ausgestaltungen stetig oder veränderlich (über die Zeit und/oder den Winkel) erfolgen.

In einer besonders vorteilhaften Ausgestaltung ist die Steuereinrichtung dazu geeignet und ausgebildet, die Bewegung des Bedienelements mittels der Bremseinrichtung in einer gezielten Abfolge zu verzögern und freizugeben. Zur Umsetzung einer solchen Abfolge ist die Steuereinrichtung insbesondere dazu geeignet und ausgebildet, unterschiedlich hohe Verzögerungsmomente für die Verzögerung und die Freigabe einzustellen. Eine solche Abfolge (Rippel) bietet ein zuverlässig wahrnehmbares haptisches Feedback auch unter schwierigen Betriebsbedingungen und ist mit der Erfindung besonders gut umsetzbar.

Die Abfolge ist insbesondere aus einer Abfolge relativer Maxima mit höherem Verzögerungsmoment und relativer Minima mit geringerem Verzögerungsmoment zusammengesetzt. Insbesondere ist ein Winkelabstand einer Periode benachbarter relativer Maxima einstellbar und wird eingestellt. Insbesondere wird der Verlauf des Verzögerungsmomentes über einer Periode in Abhängigkeit von einem eingestellten Betriebsmodus eingestellt. Eine solche Abfolge mit besonders kurzen Intervallen kann auch als Rippel/Ticks bezeichnet werden. Insbesondere wird eine solche Abfolge aus einer definierten Kombination von Verzögerungsmomenten als Funktion der Zeit und/oder des Winkels gebildet. Vorzugsweise werden die Verzögerungsmomente für die Verzögerung und/oder die Freigabe als Funktion der Zeit und/oder als Funktion des Winkels und/oder in Abhängigkeit eines Steuerbefehls eingestellt.

Die Verzögerungsmomente der Abfolge werden insbesondere winkelabhängig und/oder zeitabhängig gestartet und/oder gehalten und/oder beendet. Vorzugsweise kann auch ein Wechsel solcher Abhängigkeiten innerhalb einer Abfolge vorgesehen sein. Beispielsweise erfolgt der Start der Abfolge winkelabhängig oder zeitabhängig und die Länge der Abfolge wird dann zeitabhängig bzw. winkelabhängig eingestellt.

Vorzugsweise ist die Steuereinrichtung dazu geeignet und ausgebildet, die Verzögerungsmomente der Folge winkelabhängig zu starten und zeitabhängig aufrechtzuerhalten. Insbesondere ist die Steuereinrichtung dazu geeignet und ausgebildet, eine Einstellung eines in der Abfolge vorgesehenen Verzögerungsmoments auszulassen, wenn eine für den Start vorgesehene Winkelposition (bestimmter Drehwinkel des Bedienelements) während der Aufrechterhaltung eines Verzögerungsmoments überschwenkt wird.

Besonders bevorzugt ist die Steuereinrichtung dazu geeignet und ausgebildet, die unterschiedlichen Verzögerungsmomente der Abfolge mit einer gezielten Frequenz einzustellen und vorzugsweise mit einer solchen Frequenz einzustellen, dass die Bewegung des Bedienelements mit einem gezielten Vibrieren gedämpft wird. Insbesondere beträgt die Frequenz wenigstens 20 Hz und vorzugsweise wenigstens 50 Hz.

Die Steuereinrichtung ist insbesondere dazu geeignet und ausgebildet, die unterschiedlichen Verzögerungsmomente der Abfolge über die Zeit und/oder den Winkel und/oder die Bewegungsgeschwindigkeit (Winkelgeschwindigkeit) des Bedienelements und/oder die Anzahl bereits erfolgter Einstellungen von Verzögerungsmomenten dynamisch anzupassen.

Die Steuereinrichtung ist insbesondere dazu geeignet und ausgebildet, eine Abfolge mit sich gezielt verändernden Verzögerungsmomenten einzustellen. Insbesondere ist dazu ein sinusförmiger oder kosinusförmiger Verlauf vorgesehen. Insbesondere weist der Verlauf dazu einen (leichten) Offset im Negativen auf. Der Offset beträgt insbesondere weniger als 30 % und insbesondere weniger als 20 % und vorzugsweise weniger als 10 %. Insbesondere sind wenigstens zwei Nulldurchgänge pro Periode für den Verlauf vorgesehen. Insbesondere wird die Bremseinrichtung mit einem Sinus- bzw. Kosinussignal insbesondere mit einem vorbestimmten und insbesondere einstellbaren (leichten) Offset vom Nullpunkt gesteuert.

Bevorzugt ist, dass die Steuereinrichtung dazu geeignet und ausgebildet ist, die Bremseinrichtung mit einer Regelfrequenz von wenigstens 5 kHz und vorzugsweise wenigstens 10 kHz und besonders bevorzugt wenigstens 50 kHz anzusteuern. Insbesondere ist die Bremseinrichtung dazu geeignet und ausgebildet, eine solche Regelfrequenz umzusetzen.

Insbesondere die Steuereinrichtung dazu geeignet und ausgebildet, die Bremseinrichtung in Echtzeit zu dämpfen. Insbesondere ist die Bremseinrichtung dazu geeignet und ausgebildet, das Verzögerungsmoment in Echtzeit umzusetzen. Insbesondere ist die Dämpfung mittels der Steuereinrichtung der Bremseinrichtung in Echtzeit in Abhängigkeit an den Winkel und/oder die Zeit und/oder an einen Steuerbefehl und/oder an eine Bewegungsgeschwindigkeit bzw. Winkelgeschwindigkeit des Bedienelements anpassbar.

Insbesondere ist die Bremseinrichtung dazu geeignet und ausgebildet, das Verzögerungsmoment innerhalb weniger als 100 Millisekunden um wenigstens 30% zu verändern. Insbesondere ist das Verzögerungsmoment innerhalb weniger als 10 Millisekunden um wenigstens 10%, vorzugsweise um wenigstens 30% und besonders bevorzugt um wenigstens 50%, veränderbar. Das Verzögerungsmoment kann auch innerhalb weniger als 100 Millisekunden um wenigstens 100% oder 500% oder um das Zehnfache oder Tausendfache variierbar sein.

Die magnetorheologische Bremseinrichtung ist vorzugsweise dazu geeignet und ausgebildet, insbesondere mittels eines Sensors, Drehgebers bzw. Inkrementengebers, wenigstens 30.000 Inkremente, insbesondere 30.000 Inkremente/Umdrehung, für eine Schwenkachse des Bedienelements bereitzustellen. Inkrementalgeber beispielsweise liefern eine bestimmte Anzahl an Impulsen pro Umdrehung oder auch einen sogenannten Nullimpuls pro Umdrehung. Dies können Inkrementengeber mit UVW Signalen oder Absolutgeber sein). So können haptische Signale besonders wirkungsvoll umgesetzt werden. Insbesondere sind die Inkremente dazu einsetzbar, die zuvor beschriebenen Feedbacks und Abfolgen bereitzustellen. Insbesondere sind pro Umdrehung der Bremseinrichtung wenigstens 30.000 Inkremente bereitstellbar. Insbesondere kann das Sensormittel wenigstens 30.000 Inkremente pro Umdrehung der Bremseinrichtung umfassen.

Es ist bevorzugt und vorteilhaft, dass die Bremseinrichtung als eine magnetorheologische Übertragungseinrichtung ausgebildet ist oder wenigstens eine solche umfasst. Dabei ist vorzugsweise vorgesehen, dass die magnetorheologische Übertragungsvorrichtung mit wenigstens zwei koppelbaren Komponenten ausgestattet ist, deren Kopplungsintensität beeinflussbar ist, wobei zur Beeinflussung der Kopplungsintensität wenigstens ein Kanal vorgesehen ist, wobei der Kanal ein durch ein Magnetfeld beeinflussbares magnetorheologisches Medium mit magnetisch polarisierbaren Partikeln enthält, und wobei wenigstens eine Magnetfelderzeugungseinrichtung zur Erzeugung wenigstens eines Magnetfeldes in dem Kanal vorgesehen ist, um mit dem Magnetfeld das magnetorheologische Medium in dem Kanal zu beeinflussen, wobei die eine Komponente als äußere Komponente die andere Komponente als innere Komponente umgibt und wobei wenigstens eine der beiden Komponenten über wenigstens ein separates Lager gelagert ist und wobei ein Abstand zwischen der äußeren Komponente und der inneren Komponente wenigstens zehnmal so groß ist wie ein typischer mittlerer Durchmesser der magnetisch polarisierbaren Partikel in dem magnetorheologischen Medium und der Kanal wenigstens teilweise mit dem Magnetfeld der Magnetfelderzeugungseinrichtung beaufschlagbar ist, um die Partikel wahlweise zu verketten oder freizugeben. Insbesondere ist die Magnetfelderzeugungseinrichtung der Übertragungseinrichtung von der Steuereinrichtung ansteuerbar, um das Verzögerungsmoment gezielt einzustellen und anzupassen.

Das Bedienelement ist dann einer der beiden koppelbaren Komponenten zugeordnet und insbesondere drehfest mit dieser verbunden.

Eine für die Verwendung bei der Bremseinrichtung der Erfindung besonders vorteilhaft geeignete magnetorheologische Übertragungseinrichtung wird zum Beispiel in der DE 10 2010 055 833 A1 und in der WO 2012/034697 A1 beschrieben. Die gesamte Offenbarung der DE 10 2010 055 833 A1 und/oder der WO 2012/034697 A1 wird hiermit vorzugsweise Teil des Offenbarungsgehalts der vorliegenden Anmeldung.

Eine für die Verwendung bei der Erfindung besonders vorteilhaft geeignete magnetorheologische Bremseinrichtung wird zum Beispiel auch in der DE 10 2018 100 390 A1 und der WO 2019/138015 beschrieben. Die gesamte Offenbarung der DE 10 2018 100 390 A1 und der WO 2019/138015 werden hiermit vorzugsweise Teil des Offenbarungsgehalts der vorliegenden Anmeldung. Eine solche Bremseinrichtung kann auch als Keillager oder Magnetfeldkonzentrator bezeichnet werden.

Die zuvor beschriebenen Bremseinrichtungen können bei dem erfindungsgemäßen Eingabegerät besonders vorteilhaft eingesetzt werden. Sie können die erforderlichen Verzögerungsmomente aufbringen und auch zügig und falls nötig in Echtzeit einstellen und sind zugleich so kompakt, dass sie in der Hülle bzw. dem Mobilgerät bzw. dem Scharnier untergebracht werden können.

Die Eingabeeinrichtung einer Hülleneinrichtung oder eines Mobilgeräts weist eine magnetorheologische Bremseinrichtung auf, die an der Hülleneinrichtung oder dem Mobilgerät aufgenommen ist. Die magnetorheologische Bremseinrichtung weist wenigstens zwei Bremskomponenten auf. Eine erste Bremskomponente ist mit der Hülleneinrichtung oder dem Mobilgerät drehfest verbunden und erstreckt sich in einer axialen Richtung. Die zweite Bremskomponente umfasst ein sich um die erste Bremskomponente herum drehbares und hohl (und innen insbesondere zylindrisch) ausgebildetes Drehteil. Zwischen der ersten und der zweiten Bremskomponente ist ein umlaufender Spalt ausgebildet (Wirkspalt). Der Spalt ist wenigstens zum Teil mit einem magnetorheologischen Medium gefüllt. Dabei benetzt das magnetorheologische Medium die erste und die zweite Bremskomponente. Die erste Bremskomponente umfasst einen sich in der axialen Richtung erstreckenden Kern aus einem magnetisch leitfähigen Material und (wenigstens) eine elektrische Spule. Die elektrische Spule ist vorzugsweise in axialer Richtung um den Kern gewickelt ist und spannt vorzugsweise eine Spulenebene auf, sodass sich ein Magnetfeld der elektrischen Spule vorzugsweise quer (zu der axialen Richtung) durch die erste Bremskomponente erstreckt. Dabei ist vorzugsweise ein maximaler (äußerer) Durchmesser der elektrischen Spule in einer radialen Richtung innerhalb der Spulenebene größer als ein minimaler (äußerer) Durchmesser des Kerns in einer radialen Richtung quer (und insbesondere etwa senkrecht oder senkrecht) zu der Spulenebene.

Die erste Bremskomponente definiert eine axiale Richtung. Die erste Bremskomponente kann aber auch wenigstens örtlich zur axialen Richtung gewinkelt ausgebildet sein. Unter der Formulierung, dass sich der Kern der ersten Bremskomponente in der axialen Richtung erstreckt, wird im Sinne der vorliegenden Erfindung verstanden, dass sich der Kern wenigstens auch im Wesentlichen in die axiale Richtung erstreckt. Der Kern kann einen Verlauf aufweisen, der vorzugsweise parallel zur axialen Richtung ausgerichtet ist, aber auch einen leichten Winkel zur axialen Richtung aufweisen kann. Beispielsweise kann der Kern auch unter einem Winkel von 2,5 Grad (°) oder 5° oder 10° oder 15° zur axialen Richtung ausgerichtet sein. Die Wicklung der elektrischen Spule muss ebenso nicht exakt in axialer Richtung um den Kern ausgerichtet sein. Auch die elektrische Spule kann unter einem Winkel von 5° oder 10° oder 15° oder dergleichen zur axialen Richtung um den Kern gewickelt sein. Es ist in allen Fällen aber bevorzugt, dass ein Winkel zwischen der Ausrichtung des Kerns und der axialen Richtung und ein Winkel der Wicklung der elektrischen Spule zur axialen Richtung kleiner 20° und insbesondere kleiner 10° beträgt.

Ein besonderer Vorteil ergibt sich, wenn die elektrische Spule in axialer Richtung um wenigstens einen wesentlichen Teil des Kerns oder den Kern insgesamt um den Kern gewickelt ist. Wenn ein maximaler äußerer Durchmesser der elektrischen Spule in einer radialen Richtung innerhalb der Spulenebene größer ist als ein minimaler äußerer Durchmesser des Kerns in einer radialen Richtung quer und insbesondere wenigstens etwa senkrecht zu der Spulenebene, kann ein größerer Kerndurchmesser realisiert werden. Ein größerer Kernquerschnitt ermöglicht die Erzeugung eines stärkeren Magnetfeldes (höhere Feldstärken im Wirkspalt). Dadurch können höhere Bremskräfte bei gleichem Bauraum oder aber gleich hohe Bremskräfte bei geringerem Bauraum erzeugt werden, das erzielbare Drehmoment pro Bauvolumen nimmt damit zu. Bei Bedarf ist es auch möglich, in einem sehr kleinen Bauraum noch beachtliche Bremskräfte zu erzeugen. Das erleichtert den Einsatz in einer Hülleneinrichtung.

Das ergibt sich dadurch, dass das Magnetfeld der elektrischen Spule quer zur axialen Richtung der ersten Bremskomponente verläuft (also radial bezogen auf die Längsachse), und, dass der Durchmesser der elektrischen Spule vergrößert wird.

Im Rahmen der vorliegenden Erfindung können die Begriffe Dämpfen und Verzögern vorzugsweise synonym verwendet werden. Dabei ist die Steuereinrichtung insbesondere dazu geeignet und ausgebildet, die Bewegung des Bedienelements in beide Richtungen gezielt zu verzögern und freizugeben und bei den betriebsgemäß zu erwartenden Handkräften am Bedienelement zu blockieren.

Insbesondere ist die Steuereinrichtung dazu geeignet und ausgebildet, ein Verzögerungsmoment der Bremseinrichtung anzupassen, um die Bewegung gezielt zu dämpfen. Insbesondere die Steuereinrichtung dazu geeignet und ausgebildet, das Verzögerungsmoment dynamisch einzustellen.

Vorzugsweise kann die Steuereinrichtung ein beliebiges mit der Bremseinrichtung erzeugbares Verzögerungsmoment für einen beliebigen mit dem Bedienelement erreichbaren Drehwinkel und/oder für eine einstellbare Dauer einstellen. Insbesondere umfasst die Steuereinrichtung eine Mehrzahl von einstellbaren Betriebsmodi und ist vorzugsweise dazu geeignet und ausgebildet, in Abhängigkeit des Betriebsmodus eine Zuordnung von Verzögerungsmoment und Drehwinkel und/oder Dauer vorzunehmen.

Die Steuereinrichtung ist insbesondere eine elektronische Steuereinrichtung. Die Steuereinrichtung umfasst insbesondere wenigstens einen Steueralgorithmus. Insbesondere erfolgt die Einstellung eines Verzögerungsmoments durch Ansteuerung einer elektrischen Spuleneinrichtung der Bremseinrichtung mit einem bestimmten Strom und/oder einer bestimmten Spannung oder einem geeigneten Signal.

Im Rahmen der vorliegenden Erfindung wird unter einer Freigabe der Bewegung insbesondere verstanden, dass nur ein betriebsgemäßes Grundmoment der Bremseinrichtung vorliegt, ohne dass eine zusätzlich aufgeschaltete magnetorheologische Verzögerung, beispielsweise durch Bestromung einer Spuleneinrichtung der Bremseinrichtung, vorliegt. Wenn die Bewegung freigegeben ist, ist die magnetorheologische Bremseinrichtung insbesondere inaktiv, sodass kein Feld zur aktiven Beeinflussung eines magnetorheologischen Mediums der Bremseinrichtung erzeugt wird.

Weitere Vorteile und Merkmale der vorliegenden Erfindung ergeben sich aus der Beschreibung der Ausführungsbeispiele, die im Folgenden mit Bezug auf die beiliegenden Figuren erläutert werden.

In den Figuren zeigen:
- Fig. 1-5: rein schematische Darstellungen von erfindungsgemäßen Hülleneinrichtungen;
- Fig. 6: eine rein schematische Skizzierung eines Verlaufs eines Verzögerungsmoments über den Drehwinkel;
- Fig. 7: eine rein schematische Darstellung einer weiteren erfindungsgemäßen Hülleneinrichtung;
- Fig. 8: rein schematische Darstellungen eines erfindungsgemäßen Mobilgeräts;
- Fig. 9: einen stark schematischen Querschnitt durch einen Wälzkörper einer magnetorheologischen Bremseinrichtung;
- Fig. 10: einen schematischen Querschnitt durch eine Bremseinrichtung;
- Fig. 11: einen Querschnitt einer weiteren Bremseinrichtung;
- Fig. 12a-12d: schematische Querschnitte der Bremseinrichtungen nach Figur 10 oder 11;
- Fig. 13a-13e: eine andere Bremseinrichtung;
- Fig. 14a-d: mögliche Drehmomentverläufe über dem Drehwinkel einer Bremseinrichtung;
- Fig. 15: eine rein schematische Darstellung einer Eingabeeinrichtung mit einer Getriebeeinheit; und
- Fig. 16: eine rein schematische Darstellung einer Eingabeeinrichtung mit einer Antriebseinrichtung in einer geschnittenen Ansicht.

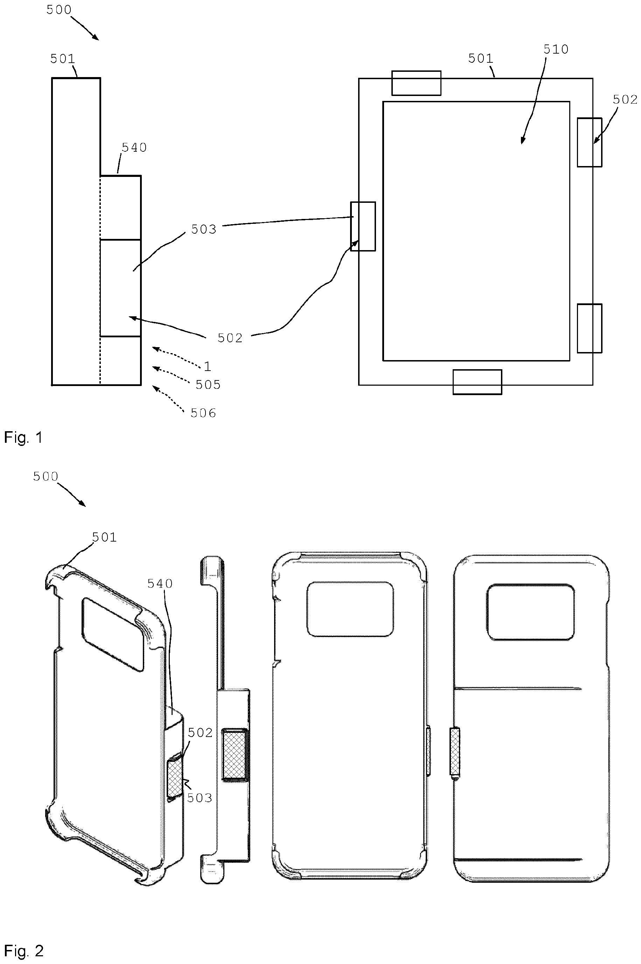

Die Figur 1 zeigt eine erfindungsgemäße Hülleneinrichtung 500 für ein hier nicht näher dargestelltes Mobilgerät 510 und beispielsweise ein Smartphone oder Tablet. Die Hülleneinrichtung 500 umfasst hier ein schalenartig ausgebildetes Hüllenteil 501, in welche das Mobilgerät 510 eingesetzt werden kann. Dabei ist die Hülleneinrichtung 500 im linken Teil der Figur in einer Seitenansicht und im rechten Teil der Figur in einer Vorderansicht gezeigt.

Das Hüllenteil 501 ist hier mit rein beispielhaft mit mehreren Eingabeeinrichtungen 502 zur Ansteuerung des Mobilgeräts 510 ausgestattet. Die Anzahl der Eingabeeinrichtungen 502 dient hier zur Veranschaulichung von möglichen Positionen am Hüllenteil 501. Das Hüllenteil 501 kann auch nur einen Teil der hier gezeigten Eingabeeinrichtungen 502 oder auch nur eine einzige Eingabeeinrichtung 502 aufweisen. Die Eingabeeinrichtungen 502 sind hier im Wesentlichen seitlich am Hülsenteil 501 angeordnet, sodass zum Beispiel ein Display des Mobilgeräts 510 unverdeckt bleibt.

Das Hüllenteil 501 kann mit hier beispielhaft skizzierten Aufnahmeeinrichtungen 507 ausgestattet sein. In die Aufnahmeeinrichtungen 507 kann jeweils wahlweise eine Eingabeeinrichtung 502 eingesetzt werden, z. B. in einer bevorzugten Bedienposition.

Die Eingabeeinrichtungen 502 sind hier jeweils mit einem als Bedienwalze bzw. Fingerwalze bzw. Daumenwalze ausgebildeten Bedienelement 503 ausgestattet. Um Eingaben in das Mobilgerät 510 vorzunehmen, kann das Bedienelement 503 um eine Drehachse gedreht werden, vorzugsweise mit dem Finger oder dem Daumen (daher der Name Finger- oder Daumenwalze). Die Drehachse ist hier innerhalb des Hüllenteils 501 angeordnet.

Ein Energiespeicher 540 und beispielsweise ein Akku dient hier zur Energieversorgung der Eingabeeinrichtung 502.

Die Drehbewegung des Bedienelements 503 wird mittels einer hier nicht sichtbar im Inneren angeordneten magnetorheologischen Bremseinrichtung 1 gezielt gedämpft.

Zur Ansteuerung der Bremseinrichtung 1 sind hier eine Sensoreinrichtung 505 und eine Steuereinrichtung 506 vorgesehen, welche ebenfalls nicht sichtbar im Inneren angeordnet sind. Die Sensoreinrichtung 505 dient zur Erfassung einer Betätigungsstellung des Bedienelements 503 und beispielsweise dessen Drehwinkel. Die Steuereinrichtung 506 steuert in Abhängigkeit der erfassten Betätigungsstellung die Bremseinrichtung 504 an.

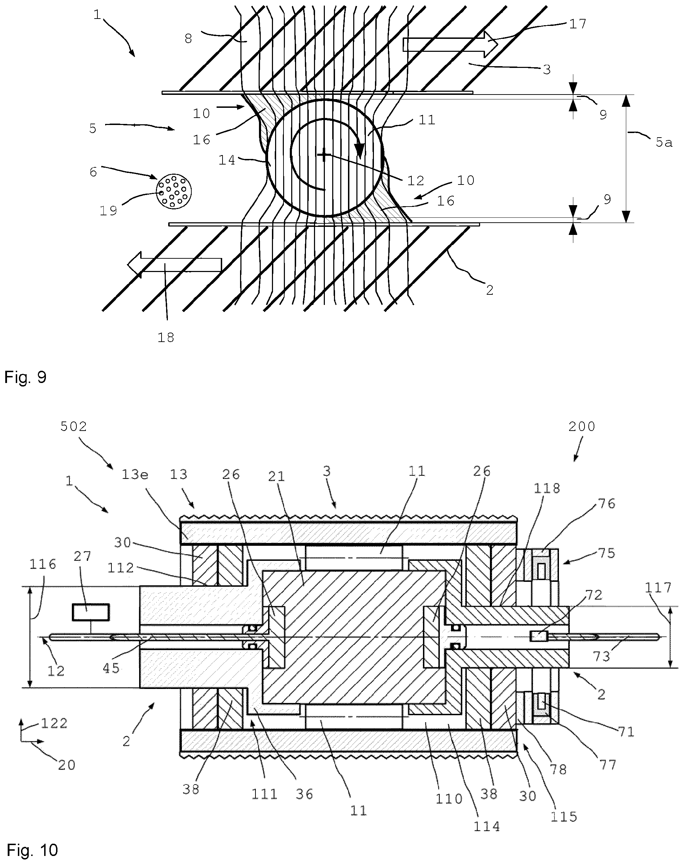

Die Bremseinrichtung 1 und ihre Ansteuerung bzw. Funktionsweise sowie ihr vorteilhafter Aufbau werden nachfolgend und insbesondere mit Bezug zu den Figuren 9 bis 14 näher beschrieben. Dabei werden die mit Bezug zu den Figuren 1 bis 8 vorgestellten Bedienelemente 503 jeweils durch eine zweite Bremskomponente 3 der Bremseinrichtung 1 nach den Figuren 9 bis 14 bereitgestellt.

Die Figur 2 zeigt eine Ausführung der zuvor beschriebenen Hülleneinrichtung 500, welche sich hier im Wesentlichen durch die Formgebung des Hüllenteils 501 von der zuvor beschriebenen Hülleneinrichtung 500 unterscheidet. Die Hülleneinrichtung 500 ist hier in einer perspektivischen Ansicht von schräg oben, einer Seitenansicht, einer Vorderansicht und einer Rückansicht gezeigt (von links nach rechts).

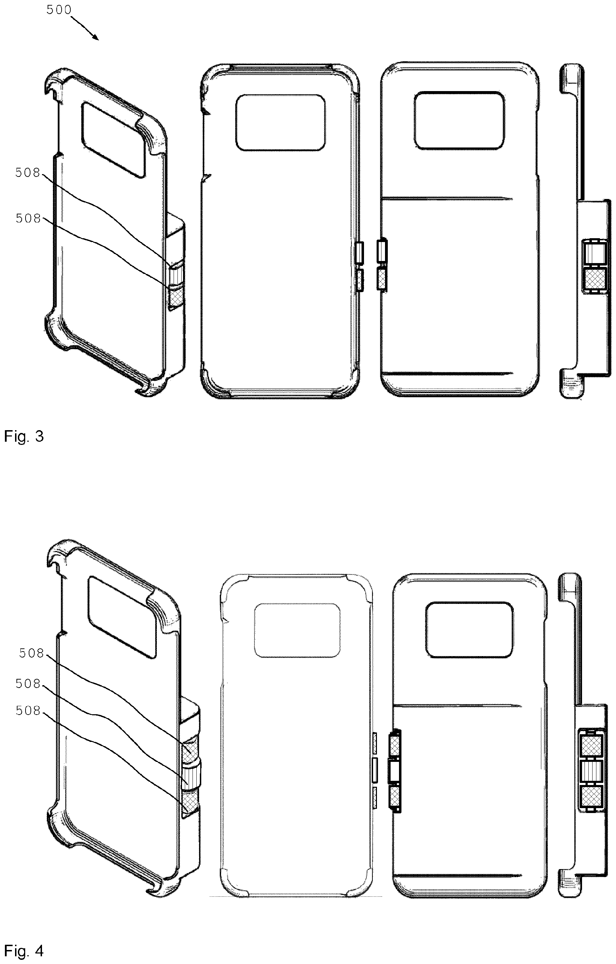

Die Figur 3 zeigt eine Ausgestaltung der mit Bezug zu der Figur 2 beschriebenen Hülleneinrichtung 500. Die hier gezeigte Eingabeeinrichtung 502 ist mit einem Bedienelement 503 ausgestattet, welches zwei unterschiedliche Betätigungszonen 508 aufweist. Die Betätigungszonen 508 sind hier axial benachbart angeordnet. Die Betätigungszonen 508 unterscheiden sich hier beispielhaft in ihrer Oberflächenstruktur.

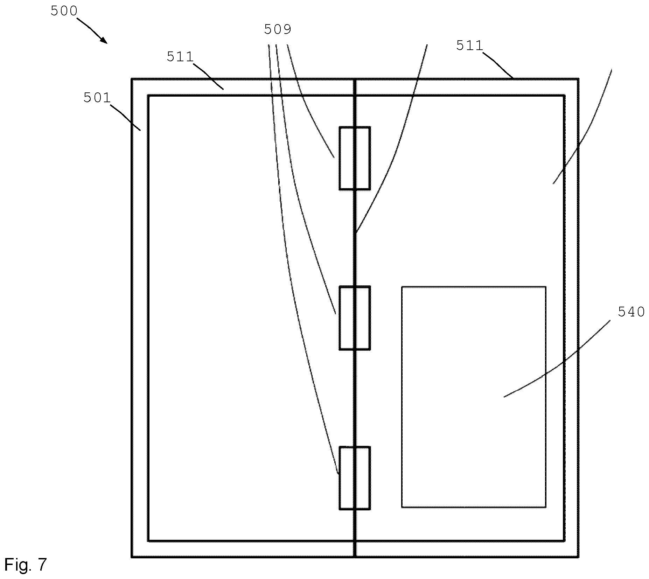

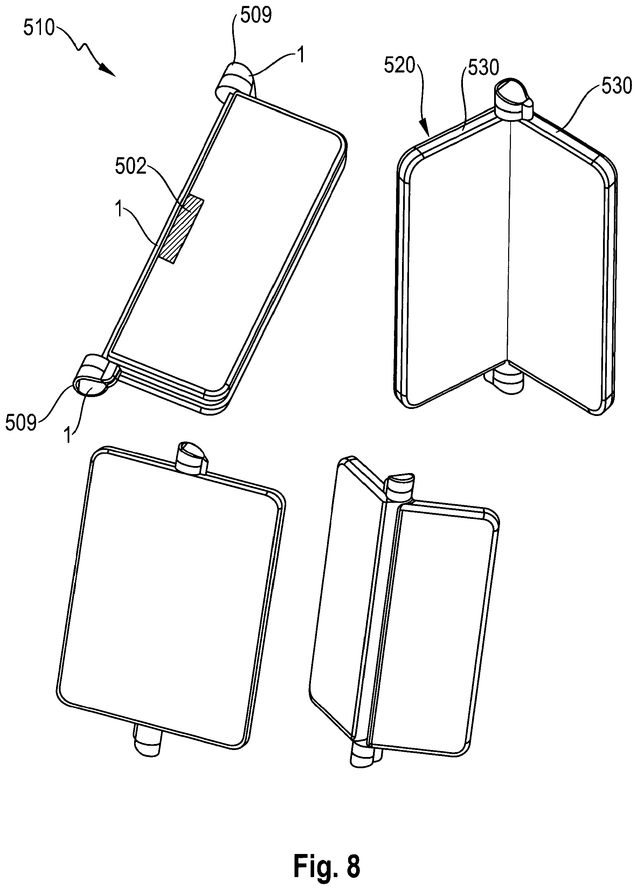

Die Bewegung des Bedienelements 503 ist hier in Abhängigkeit davon dämpfbar, über welche der Betätigungszonen 508 die Eingabe erfolgt. Dabei sind die Betätigungszonen 508 hier an eine gemeinsame Bremseinrichtung 1 angebunden, sodass ihre Bewegung nur gemeinsam bzw. nicht unabhängig voneinander gedämpft werden kann. Je nachdem, an welcher Betätigungszone 508 das Bedienelement 503 gedreht wird, erfolgt eine andere Dämpfung und/oder ein anderes haptisches Feedback. Das haptische Feedback wird nachfolgend noch näher beschrieben. Mit der einen Betätigungszone kann z. B. die eine Bildschirmhälfte der in Figur 7 und 8 gezeigten doppelten Anzeigeeinheit (Falt Smart Device) bedient werden, mit der anderen Betätigungszone die andere Hälfte. So kann z. B. in jeder Anzeigehälfte der Inhalt (z. B. Word Dokument; Zeitungsartikel) einfach gescrollt oder vertikal verfahren werden.

In der Figur 4 ist eine Ausgestaltung der Hülleneinrichtung 500 nach Figur 2 gezeigt, bei welcher das Bedienelement 503 drei Betätigungszonen 508 aufweist. Die Betätigungszonen 508 unterscheiden sich hier in ihrer Oberflächenstruktur. Zudem ist die mittlere Betätigungszone 508 hier mit einem größeren Durchmesser ausgestattet.

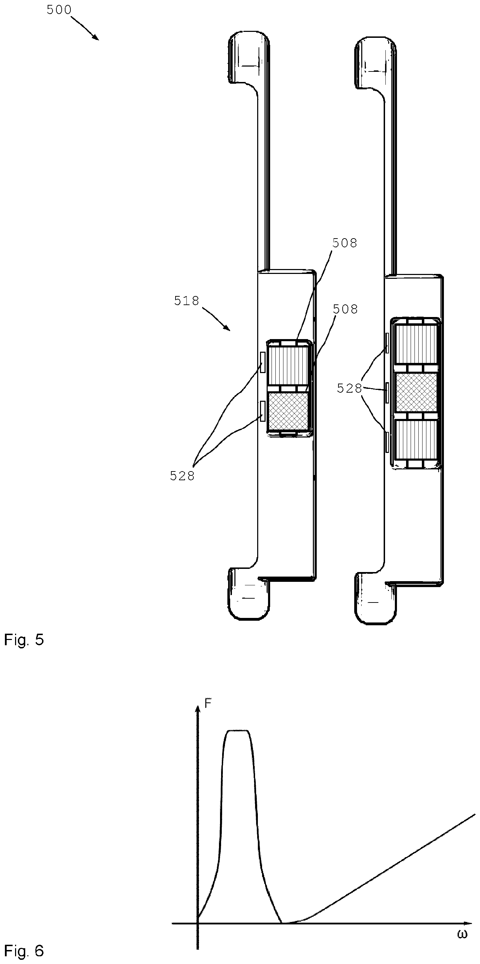

Die Figur 5 zeigt links die Ausführung des Bedienelements 503 mit zwei Betätigungszonen 508 nach Figur 3. Rechts ist die Ausführung des Bedienelements 503 mit drei Betätigungszonen 508 nach Figur 4 gezeigt.

Zur Erkennung, welche der Betätigungszonen 508 benutzt bzw. berührt wird, ist eine Überwachungseinrichtung 518 vorgesehen. Die Überwachungseinrichtung 518 umfasst hier für die Betätigungszonen 508 jeweils wenigstens einen Sensor und beispielsweise einen Näherungssensor oder Bilderkennungssystem. Dadurch kann zuverlässig ermittelt werden, an welcher Betätigungszone 508 das Bedienelement 503 berührt und gedreht wird.

Die Figur 6 zeigt einen vorteilhaften Verlauf eines Verzögerungsmoments, welcher von der Steuereinrichtung 506 mittels der Bremseinrichtung 1 an dem Bedienelement 503 eingestellt wird. Der Momentenverlauf wird nachfolgend noch näher beschrieben wird.

Die Figur 7 zeigt eine Ausgestaltung der Hülleneinrichtung 500, bei welcher das Hüllenteil 501 klappbar ausgebildet ist. Dazu sind hier zwei Hüllenabschnitte 511 über drei Scharniereinrichtungen 509 schwenkbar miteinander verbunden. Beispielsweise können die hier gezeigten Scharniereinrichtungen 509 mit jeweils einer Bremseinrichtung 1 ausgestattet sein, sodass die Schwenkbewegung gezielt gedämpft oder sogar blockiert bzw. an bestimmten Positionen fixiert werden kann.

Die hier gezeigten Scharniereinrichtungen 509 können alle oder zum Teil jeweils eine der zuvor beschriebenen Eingabeeinrichtungen 502 aufweisen. Dadurch kann von der Scharniereinrichtung 509 aus eine Bedienung des Mobilgeräts 510 erfolgen. Dabei kann vorgesehen sein, dass die Bremseinrichtung 1 für die Eingabeeinrichtung 502 zugleich auch die Schwenkbewegung der Scharniereinrichtung 509 dämpft.

Die Figur 8 zeigt ein erfindungsgemäßes Mobilgerät 510, welches hier eine klappbaren Gerätekörper 520 aufweist. Zum Klappen ist der Gerätekörper 520 hier in zwei Geräteteile 530 unterteilt, welche hier über zwei Scharniereinrichtungen 509 schwenkbar aneinander befestigt sind. Die Scharniereinrichtungen 509 sind hier jeweils mit einer magnetorheologischen Bremseinrichtung 1 ausgestattet. Dadurch kann die Schwenkbewegung gezielt gedämpft oder sogar blockiert bzw. an bestimmten Positionen fixiert werden.

Zusätzlich oder alternativ kann das Mobilgerät 510 auch mit einer hier skizzierten Eingabeeinrichtung 502 ausgestattet sein, wie sie beispielsweise mit Bezug zu den Figuren 1 bis 5 beschrieben wurde. Dabei weist die Eingabeeinrichtung 502 ein um eine Drehachse drehbares Bedienelement 503 auf. Die Drehachse ist dann vollständig innerhalb des Gerätekörpers 520 angeordnet.

Nachfolgend wird nun die Bremseinrichtung 1 näher vorgestellt.

Figur 9 zeigt eine stark schematische Querschnittsansicht einer magnetorheologischen Bremseinrichtung 1 für eine Hülleneinrichtung 500 für ein Mobilgerät 510, wie ein Mobiltelefon, ein Smartphone, Tablet oder andere Arten von Handhelds bzw. mobilen Smart Devices. Die magnetorheologische Bremseinrichtung 1 dient zur Beeinflussung der Kraftübertragung zwischen zwei Bremskomponenten 2 und 3. Dabei ist zwischen den zwei Bremskomponenten 2 und 3 in Fig. 9 ein Wälzkörper bzw. Drehkörper 11 vorgesehen. Der Wälzkörper 11 ist hier als Kugel 14 ausgebildet. Möglich ist es aber ebenso, Wälzkörper 11 als Zylinder oder Ellipsoide, Rollen oder sonstige rotierbare Drehkörper auszubilden. Auch im eigentlichen Sinn nicht rotationssymmetrische Drehkörper wie beispielsweise ein Zahnrad oder Drehkörper 11 mit einer bestimmten Oberflächenstruktur können als Wälzkörper verwendet werden. Die Wälzkörper 11 werden nicht zur Lagerung gegenüber einander eingesetzt, sondern zur Übertragung von Drehmoment.

Zwischen den Bremskomponenten 2 und 3 ist ein Kanal 5 vorgesehen, der hier mit einem Medium 6 gefüllt ist. Das Medium ist hier ein magnetorheologisches Fluid, welches beispielsweise als Trägerflüssigkeit ein Öl umfasst, in dem ferromagnetische Partikel 19 vorhanden sind. Glykol, Fett, Wasser und dickflüssige Stoffe können auch als Trägermedium verwendet werden, ohne darauf beschränkt zu sein. Das Trägermedium kann auch gasförmig sein bzw. es kann auf das Trägermedium verzichtet werden (Vakuum). In diesem Fall werden lediglich durch das Magnetfeld beeinflussbare Partikel in den Kanal gefüllt.

Die ferromagnetischen Partikel 19 sind vorzugsweise Carbonyleisenpulver, wobei die Größenverteilung der Partikel vom konkreten Einsatzfall abhängt. Konkret bevorzugt ist eine Verteilung der Partikelgröße zwischen ein und zehn Mikrometern, wobei aber auch größere Partikel von zwanzig, dreißig, vierzig und fünfzig Mikrometer möglich sind. Je nach Anwendungsfall kann die Partikelgröße auch deutlich größer werden und sogar in den Millimeterbereich vordringen (Partikelkugeln). Die Partikel können auch eine spezielle Beschichtung/Mantel (Titanbeschichtung, Keramik-, Karbonmantel etc.) aufweisen, damit sie die je nach Anwendungsfall auftretenden hohen Druckbelastungen besser aushalten. Die magnetorheologischen Partikel können für diesen Anwendungsfall nicht nur aus Carbonyleisenpulver (Reineisen), sondern z. B. auch aus speziellem Eisen (härterem Stahl) hergestellt werden.

Der Wälzkörper 11 wird durch die Relativbewegung 17 der beiden Bremskomponenten 2 und 3 vorzugsweise in Rotation um seine Drehachse 12 versetzt und läuft praktisch auf der Oberfläche der Bremskomponente 3 ab. Gleichzeitig läuft der Wälzkörper 11 auf der Oberfläche der anderen Bremskomponente 2, sodass dort eine Relativgeschwindigkeit 18 vorliegt.

Genau genommen hat der Wälzkörper 11 keinen direkten Kontakt zur Oberfläche der Bremskomponenten 2 und/oder 3 und wälzt sich deshalb nicht direkt darauf ab. Der freie Abstand 9 von dem Wälzkörper 11 zu einer der Oberflächen der Bremskomponenten 2 oder 3 beträgt z. B. 140 µm. In einer konkreten Ausgestaltung mit Partikelgrößen zwischen 1 um und 10 um liegt der freie Abstand insbesondere zwischen 75 um und 300 um und besonders bevorzugt zwischen 100 um und 200 µm.

Der freie Abstand 9 beträgt insbesondere wenigstens das Zehnfache des Durchmessers eines typischen mittleren Partikeldurchmessers. Vorzugsweise beträgt der freie Abstand 9 wenigstens das Zehnfache eines größten typischen Partikels. Durch den fehlenden direkten Kontakt ergibt sich eine sehr geringe(s) Grundreibung/-kraft/- moment beim relativen Bewegen der Bremskomponenten 2 und 3 zueinander.

Wird die magnetorheologische Bremseinrichtung 1 mit einem Magnetfeld beaufschlagt, bilden sich die Feldlinien abhängig vom Abstand zwischen den Wälzkörpern 11 und den Bremskomponenten 2, 3 aus. Der Wälzkörper 11 besteht aus einem ferromagnetischen Material und z. B. hier aus ST 37 (S235). Der Stahltyp ST 37 hat eine magnetische Permeabilität ur von etwa 2000. Die Feldlinien (Magnetkreis) treten durch den Wälzkörper hindurch und konzentrieren sich in dem Wälzkörper. An der hier radialen Ein- und Austrittsfläche der Feldlinien an dem Wälzkörper herrscht eine hohe magnetische Flußdichte in dem Kanal 5. Das dort inhomogene und starke Feld führt zu einer lokalen und starken Vernetzung der magnetisch polarisierbaren Partikel 19 (magnetische Verkettung). Durch die Drehbewegung des Wälzkörpers 11 in Richtung auf den sich bildenden Keil in dem magnetorheologischen Fluid wird die Wirkung stark erhöht und das mögliche Brems- oder Kupplungsmoment wird extrem vergrößert, weit über den Betrag hinaus, der normalerweise in dem magnetorheologischen Fluid erzeugbar ist. Vorzugsweise bestehen Wälzkörper 11 und Bremskomponenten 2, 3 zumindest teilweise aus ferromagnetischem Material, weshalb die magnetische Flussdichte umso höher wird, je kleiner der Abstand zwischen Drehkörper 11 und Bremskomponenten 2, 3 ist. Dadurch bildet sich ein im Wesentlichen keilförmiger Bereich 16 im Medium aus, in welchem der Gradient des Magnetfelds zum spitzen Winkel bei der Kontaktstelle bzw. dem Bereich des geringsten Abstands hin stark zunimmt.

Trotz Abstand zwischen Wälzkörper 11 und Bremskomponenten 2, 3 kann durch die Relativgeschwindigkeit der Oberflächen zueinander der Wälzkörper 11 in eine Drehbewegung versetzt werden. Die Drehbewegung ist ohne und auch mit einem wirkenden Magnetfeld 8 möglich.

Wenn die magnetorheologische Bremseinrichtung 1 einem Magnetfeld 8 einer hier in Figur 9 nicht dargestellten elektrischen Spule 26 ausgesetzt ist, verketten sich die einzelnen Partikeln 19 des magnetorheologischen Fluides 6 entlang der Feldlinien des Magnetfeldes 8. Zu beachten ist, dass die in Figur 9 eingezeichneten Vektoren den für die Beeinflussung des MRF relevanten Bereich der Feldlinien nur grob schematisch darstellen. Die Feldlinien treten im Wesentlichen normal auf die Oberflächen der ferromagnetischen Bauteile in den Kanal 5 ein und müssen vor allem im spitzwinkligen Bereich 10 nicht geradlinig verlaufen.

Gleichzeitig wird auf dem Umfang des Wälzkörpers 11 etwas Material von dem magnetorheologischen Fluid mit in Rotation versetzt, sodass sich ein spitzwinkliger Bereich 10 zwischen der Bremskomponente 3 und dem Wälzkörper 11 ausbildet. Auf der anderen Seite entsteht ein gleicher spitzwinkliger Bereich 10 zwischen dem Wälzkörper 11 und der Bremskomponente 2. Die spitzwinkligen Bereiche 10 können beispielsweise bei zylinderförmig ausgestalteten Wälzkörpern 11 eine Keilform 16 aufweisen. Durch die Keilform 16 bedingt wird die weitere Rotation des Wälzkörpers 11 behindert, sodass die Wirkung des Magnetfeldes auf das magnetorheologische Fluid verstärkt wird, da sich durch das wirkende Magnetfeld innerhalb des spitzwinkligen Bereiches 10 ein stärkerer Zusammenhalt des dortigen Mediums 6 ergibt. Dadurch wird die Wirkung des magnetorheologischen Fluids im angesammelten Haufen verstärkt (die Kettenbildung im Fluid und damit der Zusammenhalt bzw. die Viskosität), was die weitere Rotation bzw. Bewegung des Drehkörpers 11 erschwert.

Durch die Keilform 16 (Partikelanhäufung) können wesentlich größere Kräfte oder Momente übertragen werden als es mit einem vergleichbaren Aufbau möglich wäre, der nur die Scherbewegung ohne Keileffekt nützt.

Die direkt durch das angelegte Magnetfeld übertragbaren Kräfte stellen nur einen kleinen Teil der durch die Vorrichtung übertragbaren Kräfte dar. Durch das Magnetfeld lässt sich die Keilbildung und somit die mechanische Kraftverstärkung steuern. Die mechanische Verstärkung des magnetorheologischen Effekts kann soweit gehen, dass eine Kraftübertragung auch nach Abschalten eines angelegten Magnetfeldes möglich ist, wenn die Partikel verkeilt wurden.

Es hat sich herausgestellt, dass durch die Keilwirkung der spitzwinkligen Bereiche 10 eine erheblich größere Wirkung eines Magnetfeldes 8 einer bestimmten Stärke erzielt wird. Dabei kann die Wirkung um ein Vielfaches verstärkt werden. In einem konkreten Fall wurde eine etwa zehnmal so starke Beeinflussung der Relativgeschwindigkeit zweier Bremskomponenten 2 und 3 zueinander wie beim Stand der Technik bei MRF Kupplungen nach dem Scherprinzip beobachtet, bei dem zwischen zwei sich zueinander bewegenden Flächen ein magnetorheologisches Fluid angeordnet ist und den Scherkräften der sich zueinander bewegenden Flächen ausgesetzt ist. Die mögliche Verstärkung hier durch die Keilwirkung hängt von unterschiedlichen Faktoren ab. Gegebenenfalls kann sie durch eine größere Oberflächenrauhigkeit der Wälzkörper 11 noch verstärkt werden. Möglich ist es auch, dass auf der Außenoberfläche der Wälzkörper 11 nach außen ragende Vorsprünge vorgesehen sind, die zu einer noch stärkeren Keilbildung führen können.

Die Keilwirkung bzw. der Keileffekt verteilt sich flächig auf den Wälzkörper 11 und die Komponenten 2 oder 3.

Figur 10 zeigt einen Schnitt durch ein Eingabeeinrichtung 502, welches eine Gerätekomponente 200 bildet. Die Eingabeeinrichtung 502 umfasst eine magnetorheologischen Bremseinrichtung 1, die über zwei Bremskomponenten 2 und 3 verfügt. Die erste Bremskomponente 2 und die zweite Bremskomponente 3 erstrecken sich im Wesentlichen in eine axiale Richtung 20. Die erste Bremskomponente 2 ist hier im Inneren der zweiten Bremskomponente 3 angeordnet und wird durch einen Halter 4 formschlüssig und/oder kraftschlüssig gehalten. Der Halter 4 wird regelmäßig an der Hülleneinrichtung 500 oder an einem Mobilgerät 510 befestigt. Die zweite Bremskomponente 3 ist relativ zu der ersten Bremskomponente 2 kontinuierlich drehbar daran aufgenommen. Die zweite Bremskomponente 3 bildet das drehbare Bedienelement 503, welches z. B. mit einem Finger eines Benutzers bedienbar ist.

Die zweite Bremskomponente 3 ist länglich ausgebildet und verfügt über das Drehteil 13 und darin ein magnetisch leitfähiges Hülsenteil 13e.

Die zweite Bremskomponente 3 ist an der ersten Lagerstelle 112 und an der zweiten Lagerstelle 118 an der zweiten Bremskomponente 2 drehbar aufgenommen und kann auch axial verschiebbar gelagert sein. An den Lagerstellen 112, 118 können Kräfte in eine globale radiale Richtung 122 durch die Lagerungen 30 abgestützt werden, während die erste Bremskomponente 2 relativ axial zur zweiten Bremskomponente 3 verschiebbar ist. Der Durchmesser 116 der ersten Lagerstelle 112 ist hier ungefähr doppelt so groß wie der Durchmesser 117 der zweiten Lagerstelle 118.

Die zweite Bremskomponente 3 ist an beiden Enden herausgeführt. Zwischen den Bremskomponenten 2 und 3 ist eine geschlossene Kammer 110 ausgebildet, die mit einem magnetorheologischen Fluid (MRF) gefüllt ist. Im Bereich des ersten Endes 111 der Kammer 110 ist eine zylindrische Lauffläche an dem Halter 4 als erste Lagerstelle 112 ausgebildet. Dort liegt eine gehärtete Oberfläche oder eine Oberfläche entsprechender Güte vor. An dieser zylindrischen Lauffläche 37 ist ein Lager 30 zur drehbaren Lagerung der zweiten Bremskomponente 3 angebracht. In der axialen Richtung 20 weiter nach innen ist benachbart zu dem Lager 30 eine Dichtung 38 vorgesehen. Die Dichtung 38 dichtet das Innere zuverlässig ab.

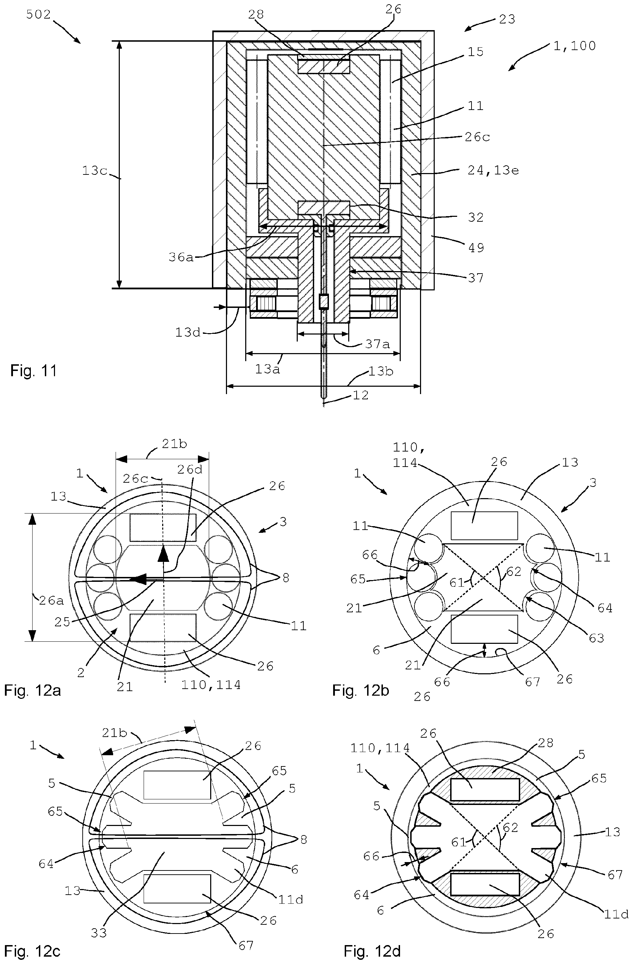

Die erste Bremskomponente 2 weist einen Grundkörper 33 auf. Um den Kern 21 sind die Wicklungen einer elektrischen Spule 26 gewickelt. Dabei stehen die die einzelnen Windungen der elektrischen Spule 26 nach außen über den zylindrischen Grundkörper 33 hervor (vgl. Fig. 12).

Radial besteht zwischen der Außenwandung der ersten Bremskomponente 2 und der inneren Wandung des Hülsenteils 13 ein Spalt 5, der hier im Wesentlichen als hohlzylindrischer Spalt ausgeführt ist. In dem Spalt sind mehrere Übertragungskomponenten 11, die hier als Wälzkörper ausgebildet sind, angeordnet. Die Wälzkörper 11 sind hier als zylindrische Wälzkörper ausgebildet und weisen einen Außendurchmesser auf, der etwas geringer ist als die Spaltenbreite des Spaltes 5. Der Spalt 5 ist des Weiteren hier mit einem magnetorheologischen Medium gefüllt.

Im einem Bereich des Spaltes kann beispielsweise ein mit Luft oder einem anderen Gas gefüllter O-Ring oder dergleichen angeordnet sein, der einen Volumenausgleich bei Temperaturschwankungen zur Verfügung stellt. Außerdem wird dadurch dort ein Reservoir gebildet, falls im Laufe des Betriebes magnetorheologisches Fluid bzw. Medium aus dem Inneren nach außen austritt. Hier wird die Konstruktion genutzt, um durch die unterschiedlich großen Durchmesser 116, 117 einen automatischen Temperaturausgleich und ein Reservoir für MRF zur Verfügung zu stellen.

Die (nutzbare) Spaltlänge des Spaltes 5 ist hier größer als die Länge der Wälzkörper 11. Hier ist auch die elektrische Spule in der axialen Richtung 20 länger ausgebildet als die Länge der Wälzkörper 11.

Im Inneren der elektrischen Spule 26 ist der Kern 21 zu erkennen. Der Halter 4 weist eine radial vergrößerte Aufnahme 36 (Durchmesser 36a, vgl. Fig. 11) zur drehfesten Aufnahme der ersten Bremskomponente 2 auf. Durch den Halter 4 erstreckt sich eine Kabeldurchführung nach unten durch den Halter 4 hindurch. Dort werden Kabel 45 zum Anschluss der elektrischen Spule 26 und gegebenenfalls Sensorleitungen herausgeführt. Eine Steuereinrichtung 27 kann im Fuß des Halters 4 oder an anderen geeigneten Stellen vorgesehen oder zugeordnet sein, um eine bedarfsgerechte Steuerung vorzunehmen.

Zwischen dem ersten Ende 111 und dem zweiten Ende 115 ist eine geschlossene Kammer 110 ausgebildet. Die geschlossene Kammer 110 umfasst das Volumen 114, welche im Wesentlichen vollständig mit dem magnetorheologischen Medium 6 gefüllt ist.

Eine Änderung des Volumens der magnetorheologischen Mediums 6 führt hier zu einer relativen axialen Verschiebung der ersten Bremskomponente 2 zur zweiten Bremskomponente 3 aufgrund der verschiedenen Durchmesser 116, 117 der beiden Lagerstellen 112, 118.

Für den Fall, dass die erste Bremskomponente 2 feststeht, wird die zweite Bremskomponente 3 im Falle einer Volumenzunahme in der Orientierung von Figur 3 nach rechts verschoben. Ein kleiner Teil der ersten Bremskomponente 2 mit dem Durchmesser 116 an der ersten Lagerstelle 112 tritt aus der geschlossenen Kammer 110 aus, während ein Teil der ersten Bremskomponente 2 an dem zweiten Ende 115 mit dem deutlich kleineren Durchmesser in die geschlossene Kammer 110 eintritt. Im Endeffekt wird so das Volumen 114 der geschlossenen Kammer 110 vergrößert. So kann insbesondere eine durch einen Temperaturanstieg bedingte Volumenänderung des magnetorheologischen Mediums 6 ausgeglichen werden. Eine Funktion der Magnetfelderzeugungseinrichtung 113 wird hierdurch nicht beeinflusst. Im Falle einer Volumenabnahme, welche temperaturbedingt oder auch durch eine Leckage zustande kommen kann, wird die zweite Bremskomponente 3 hier nach links verschoben.

Bei der Verschiebung herrscht innerhalb der magnetorheologischen Bremskomponente 1 praktisch immer Umgebungsdruck. Vor allem wird so eine zusätzliche Belastung der Dichtungen 38 verhindert. Bei einer Ausgleichseinrichtung über eine Gasblase wird der Innenraum hingegen immer unter Überdruck gesetzt, wodurch eine höhere Leckage und eine höhere Reibung durch die erforderliche bessere Dichtung entstehen.

Es kann ein Ausgleichskanal 120 vorgesehen sein, welcher die Bereiche nahe der Lagerstellen 112, 118 miteinander verbindet. So wird bei einer Verschiebung des magnetorheologischen Mediums 6 die Drosselwirkung des Spalts gemindert, sofern dieser sehr klein sein sollte.

Darüber hinaus verfügt die magnetorheologische Bremseinrichtung 1 über eine Sensoreinrichtung 70 wenigstens zur Detektion einer Winkelstellung der beiden Bremskomponenten 2, 3 relativ zueinander. Die Detektion erfolgt mit einer Magnetringeinheit 71 und mittels eines Magnetfeldsensors 72. Die Sensoreinrichtung 70 ist hier über eine Entkopplungseinrichtung 78 an der zweiten Bremskomponente 3 angeschlossen. Die Entkopplungseinrichtung 78 entkoppelt die Sensoreinrichtung magnetisch. Die Sensoreinrichtung 70 umfasst hier weiter eine Abschirmeinrichtung 75, die hier mehrere Abschirmkörper 76 umfasst und die die Magnetringeinheit 71 auf drei Seiten umgibt. Zwischen der Magnetringeinheit und der Abschirmeinrichtung 75 ist eine Trenneinheit 77 vorhanden. Die Trenneinheit 77 schirmt die Magnetringeinheit 71 zusätzlich ab. Dadurch wird das von der Magnetringeinheit 71 aufgespannte Volumen weitgehend von magnetischen Einflüssen der elektrischen Spule 26 oder anderen Magnetfeldern abgeschirmt.

Figur 11 zeigt eine andere Eingabeeinrichtung 502 im Schnitt mit einer ähnlichen magnetorheologischen Bremseinrichtung 1. Das Bedienelement 503 der Eingabeeinrichtung 502 ist entweder einseitig an der Hülleneinrichtung 500 aufgenommen oder es ist an dem zweiten Ende noch ein Achsstummel ausgebildet, um das Bedienelement 503 der Eingabeeinrichtung 502 drehbar zu lagern.

Es sind die Quernuten 32 erkennbar, in denen die elektrische Spule 26 an den axialen Enden des Kerns 21 gewickelt ist. In axialer Richtung ist zum Abschluss an beiden Enden jeweils Vergussmasse 28 vorgesehen. Im Bereich der Kabeldurchführung 35 ist eine separate Dichtung über beispielsweise den eingezeichneten O-Ring oder dergleichen vorgesehen.

Es ist auch möglich, dass einzelne der über einem Teil des Umfangs verteilt angeordneten Wälzkörper als magnetisch nicht leitfähige Übertragungskomponenten ausgebildet sind. Vorzugsweise sind alle Wälzkörper aus magnetisch leitendem Material wie z. B. Stahl.

Eine Länge bzw. Höhe 13c des Drehteils 13 und des Hülsenteils 13e oder der zweiten Bremskomponente 3 in axialer Richtung 20 beträgt vorzugsweise zwischen 3 mm und 90 mm und insbesondere zwischen 5 mm und 30 mm. Außen kann auf der zweiten Bremskomponente 3 ein Überzug 49 angebracht sein, sodass das äußere Erscheinungsbild des Drehknopfes 23 im Wesentlichen durch die Oberfläche des Überzugs 49 bestimmt wird. Durch unterschiedliche Oberflächen können unterschiedliche Segmente unterschieden werden.

Das Material des Hülsenteils 13e oder des Drehteils 13 insgesamt ist magnetisch leitend und dient zur Schließung des Magnetkreises. Eine Wandstärke 13d des Hülsenteils 13e ist vorzugsweise wenigstens halb so groß wie ein Durchmesser der Wälzkörper 11.

Der Durchmesser 36a der Aufnahme 36 ist vorzugsweise erheblich größer als der Durchmesser 37a der zylindrischen Lauffläche 37. Dadurch wird die Reibung an der Dichtung 38 reduziert. Außerdem können standardisierte Lager eingesetzt werden.

Es ist auch möglich, den Kern 21 und auch den Halter 4 zweiteilig auszuführen. Bevorzugt verläuft die Trennung entlang der in Figur 11 gezeichneten Mittellinie, wodurch sich eine linke und rechte (Kern)hälfte ergibt. Die zwei Kernhälften können durch ein magnetisch nicht leitendes Element (z. B. Dichtung) voneinander beabstandet sein. Vorzugsweise ist das Vergussmassenvolumen 28 dann ein Teil der Kernhälfte(n), wodurch sich ein Halbkreiselement mit einer umlaufenden Nut auf der Trennfläche für die Elektrospule ergibt. Weiters bevorzugt wird die Aufnahme 36 auch in zwei Hälften getrennt. Eine Aufnahmehälfte kann auch mit einer Kernhälfte einen Teil bilden (einteilig ausgeführt werden) oder eine Kernhälfte mit einer kompletten Aufnahmeeinheit 36 einteilig ausgeführt werden.

Hier ist die Eingabeeinrichtung 502 mit der magnetorheologischen Bremseinrichtung 1 einseitig gelagert. Die zweite Bremskomponente 3 ist hier nur an dem ersten Ende der geschlossenen Kammer 110 an einem Endabschnitt 121 der ersten Bremskomponente 2 aufgenommen, d. h. die zweite Bremskomponente 3 ist lediglich an der ersten Lagerstelle 112 durch die Lagerung 30 gelagert. Bei einer Änderung des Volumens innerhalb der geschlossenen Kammer kann sich die zweite Bremskomponente 3 leicht hin und her bewegen. Hierbei ist wieder angenommen, dass die erste Bremskomponente 2 feststeht. In diesem Fall fährt ein Teil des Durchmessers 116 der ersten Bremskomponente 2 an der ersten Lagerstelle 112 aus oder ein. Das Volumen 114 der geschlossenen Kammer 110 verändert sich. Vorteilhaft ist das System innerhalb des gegebenen Bewegungsspielraums praktisch immer bei Umgebungsdruck. Eine zusätzliche Belastung der Dichtung 38 wird verhindert.

Figuren 12a bis 12d zeigen verschiedene schematische Querschnitte der magnetorheologischen Bremseinrichtung 1, die bei den Eingabeeinrichtungen 502 nach Figuren 10 und 11 und auch anderen Ausführungsbeispielen einsetzbar sind.

Die innere Bremskomponente 2 ist feststehend ausgebildet und wird von der kontinuierlich drehbaren Bremskomponente 3 umgeben. Die zweite Bremskomponente 3 weist ein sich um die erste Bremskomponente herum drehbares und hohl und innen zylindrisch ausgebildetes Drehteil 13 auf. Deutlich erkennbar ist der zwischen der ersten und der zweiten Bremskomponente 2, 3 umlaufende Spalt 5. Der Spalt 5 ist hier wenigstens zum Teil und insbesondere vollständig mit einem magnetorheologischen Medium 6 gefüllt.

Die erste Bremskomponente 2 weist den sich in der axialen Richtung 20 erstreckenden Kern 21 aus einem magnetisch leitfähigen Material und eine elektrische Spule 26 auf, die in axialer Richtung 20 um den Kern 21 gewickelt ist und eine Spulenebene 26c aufspannt. Das Magnetfeld 8 der elektrischen Spule 26 erstreckt sich quer zu der axialen Richtung 20 durch die erste Bremskomponente 2 bzw. den Kern 21.

Es ist klar erkennbar, dass ein maximaler äußerer Durchmesser 26a der elektrischen Spule 26 in einer radialen Richtung 26d innerhalb der Spulenebene 26c größer ist als ein minimaler äußerer Durchmesser 21b des Kerns 21 in einer radialen Richtung 25 quer und z. B. senkrecht zu der Spulenebene 26c.

Die Wälzkörper 11 sind jeweils nur in Winkelsegmenten 61, 62 angeordnet und können nicht vollständig um den Kern 21 rotieren, da die elektrische Spule 26 in den Spalt 5 bzw. Kanal hineinragt und damit einen vollständigen Umlauf verhindert.

Dadurch steht weniger Platz für die Wälzkörper 11 zur Verfügung.

Das führt aber zu einer noch höheren Konzentration des Magnetfeldes 8. In Figur 12a sind beispielhaft drei Magnetfeldlinien eingezeichnet.

In Figur 12b sind die Wälzkörper 11 nicht an einer zylindrischen Außenoberfläche des Kerns 21 aufgenommen, sondern an speziell an die Kontur der Wälzkörper 11 angepasste Aufnahmen 63, an denen die Wälzkörper 11 vorzugsweise mit etwas Spiel aufgenommen und geführt sind. Der Übergang des Magnetfeldes 8 in die Wälzkörper 11 hinein ist vorteilhaft, da mehr Übertragungsfläche zwischen dem Kern 21 bzw. der Außenoberfläche 64 an den Aufnahmen 63 und den Wälzkörpern 11 zur Verfügung steht.

Die elektrische Spule ist außerhalb der Winkelsegmente 61 und 62 angeordnet. Außerhalb der Winkelsegmente 61 und 62 befinden sich keine Wälzkörper 11.

Figuren 12c und 12d zeigen Fortentwicklungen, bei denen auf Wälzkörper 11 vollständig verzichtet wird. Die Kerne 21 weisen nach außen abstehende Übertragungskomponenten 11 auf, die sich von dem Grundkörper 33 aus radial nach außen erstrecken. In Fig. 12c ist die Kammer 110 zwischen dem Kern 21 und dem Drehteil 13 vollständig mit MRF gefüllt.

Der maximale äußere Durchmesser 26a der Spule 26 ist größer als der minimale Kerndurchmesser 21b. Die radiale Erstreckung des Spaltes 5 variiert über dem Umfang. An den äußeren Enden der Übertragungskomponenten 11 liegt nur ein geringes Spaltmaß 65 vor, während ein radialer Abstand 66 zwischen der Bremskomponente 2 und der Bremskomponente 3 an anderen Stellen erheblich größer ist.

Figur 12d zeigt eine Variante von Fig. 12c, bei der zur Verkleinerung des MRF-Volumens die Kammer über einen zylindrischen Abschnitt mit Vergussmasse 28 gefüllt ist. Dadurch sinkt das benötigte Volumen an MRF. Der radiale Abstand 66 wird deutlich verkleinert, bleibt aber erheblich (wenigstens Faktor 2 oder 3 oder 5 oder 10) größer als das radiale Spaltmaß 65. Dadurch wird sichergestellt, dass der beschriebene Keileffekt auftritt. Die MRF-Partikel verketten sich in den spitzwinkligen Bereichen und bilden eine Art Keil, der zu einem erheblichen Bremsmoment führt. In den Figuren 12c und 12d bilden die Übertragungskomponenten 11 eine Art von radialen Armen 11d.

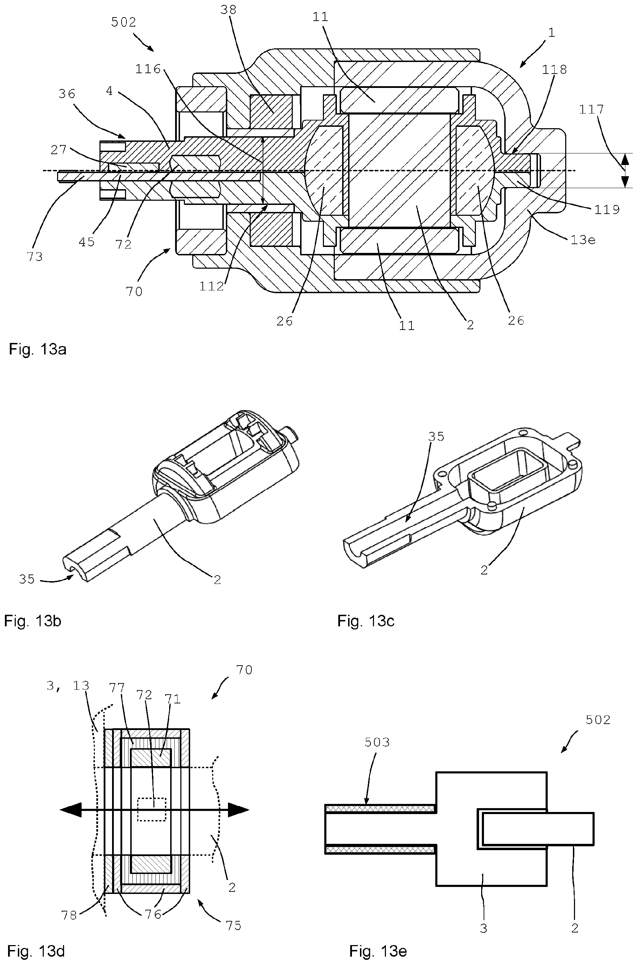

Figuren 13a bis 13d zeigen eine weitere Ausführungsform einer Eingabeeinrichtung 502 für eine Hülleinrichtung 500 oder ein Mobilgerät 510, die hier wieder über eine magnetorheologische Bremseinrichtung 1 verfügt und Bremskomponenten 2 und 3 umfasst. Es wird wieder eine "liegende oder axiale Spule" verwendet, bei der die elektrische Spule 26 in axialer Richtung 20 um den Kern 21 gewickelt ist und wieder einen maximalen radialen Spulendurchmesser 26a aufweist, der größer ist als ein minimaler Kerndurchmesser 21b des Kerns 21. Auch hier sind die Wälzkörper oder Übertragungselemente nicht über dem vollständigen Umfang angeordnet.

Hier ist die Gerätekomponente 200 als Eingabeeinrichtung 502 ausgeführt. Die zweite Bremskomponente 3 ist an dem ersten Ende der geschlossenen Kammer 110 an der Lagerstelle 112 aufgenommen. Außerdem ist die zweite Bremskomponente 3 an der zweiten Lagerstelle 118 an der ersten Bremskomponente 2 aufgenommen. Hier wird die Lagerung mittels eines Achsstummels 119 mit dem Durchmesser 117 an der zweiten Lagerstelle 118 realisiert. Der Dichtring 46 hindert das magnetorheologische Medium daran, in den Bereich hinter den Achsstummel 119 zu fließen.

Der Durchmesser 117 an der zweiten Lagerstelle 118 ist hier deutlich kleiner ausgeführt als der Durchmesser 116 an der ersten Lagerstelle 112. So wird auch hier bei einer axialen Verschiebung eine Volumenänderung ermöglicht. Temperaturbedingte Volumenänderungen und durch Leckagen bedingte Volumenänderungen können kompensiert werden. Hierzu erfolgt eine relative axiale Verschiebung der ersten Bremskomponente 2 zur zweiten Bremskomponente 3.

Außerdem ist auch hier eine Sensoreinrichtung 70 zur Detektion einer Winkelstellung der Eingabeeinrichtung 502 vorhanden. Der Magnetfeldsensor 72 ist in der feststehenden Aufnahme 4 bzw. der ersten Bremskomponente 2 integriert. An der Aufnahme 36 ist das Kabel 45 des Magnetfeldsensors 72, d. h. die Sensorleitung 73 durch die Kabeldurchführung 35 nach außen geführt.

Das erste Achsteil bzw. der Halter der Bremskomponente 2 kann, wie in Figuren 13b und 13c dargestellt, bevorzugt zweiteilig ausgeführt sein. Dadurch wird vor allem die Montage der elektrischen Leitungen und insbesondere der Sensorleitung 73 innerhalb der ersten Bremskomponente 2 vereinfacht. Die Kabel können durch die offene Kabeldurchführung 35 gelegt werden.

In Figur 13d ist die Sensoreinrichtung 70 noch einmal im Detail dargestellt. Die erste Bremskomponente 2 und die hier als Drehteil ausgeführte zweite Bremskomponente 3 sind nur angedeutet (gestrichelte Linien). Die Sensoreinrichtung 70 stützt sich über die Entkopplungseinrichtung 78 an der drehbaren zweiten Bremskomponente 3 magnetisch entkoppelt ab. Die Abschirmeinrichtung 75 besteht hier aus drei Abschirmkörpern 76, welche die Streuung des magnetischen Felds 8 der elektrischen Spule 26 vermindern. Darüber hinaus ist außerdem noch eine Trenneinheit 77 zur magnetischen Trennung vorhanden. Die Magnetringeinheit 71 wird zum Messen der Orientierung bzw. des Drehwinkels der magnetorheologischen Bremseinrichtung 1 genutzt. Der Magnetfeldsensor 72 ist innerhalb der ersten Bremskomponente 2 angeordnet. Kleine relative axiale Verschiebungen können außerdem genutzt werden, um ein Herunterdrücken beispielsweise eines Bedienknopfs 101 zu detektieren.

Figur 13e zeigt eine stark schematische Ansicht einer Bedieneinrichtung 502, bei welcher die innere Bremskomponente 2 feststehend ausgeführt ist und von der drehbaren Bremskomponente 3 umgeben ist. Dazu kann die Bremskomponente 3 einen Stiftabschnitt und einen hohlzylindrischen Abschnitt aufweisen. Der Stiftabschnitt kann angefasst und gedreht werden, während in dem hohlzylindrischen Abschnitt die Bremsfunktion realisiert wird. Eine solche Ausgestaltung ist in allen Ausführungsformen möglich.

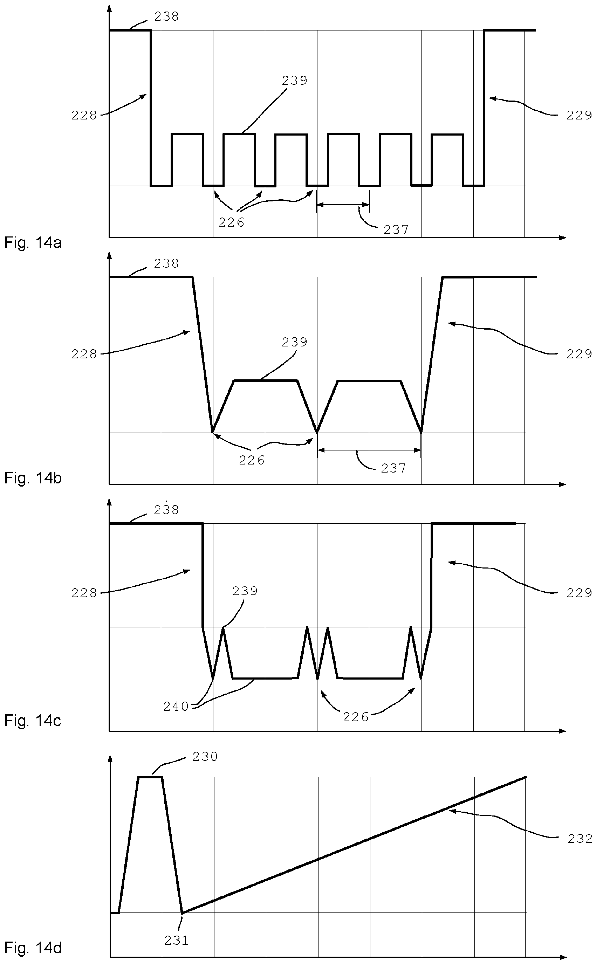

In den Figuren 14a, 14b und 9c sind mögliche Ausführungsvarianten zur Steuerung eines dynamisch erzeugten Magnetfeldes bzw. eines dynamisch erzeugten Bremsmoments in Abhängigkeit von dem Drehwinkel dargestellt.

Figur 14a zeigt dabei eine Variante, bei der die Eingabeeinrichtung 502 als Walze und haptische Bedienhilfe eingesetzt wird. Dargestellt ist der Drehwiderstand über dem Drehwinkel. Mit der Steuerung 27 kann ein linker Endanschlag 228 und ein rechter Endanschlag 229 erzeugt werden. Beim Weiterdrehen des Drehknopfes 23 wird dort ein hohes Magnetfeld bzw. Anschlagmoment 238 erzeugt, wodurch der Drehknopf 23 einen hohen Widerstand gegenüber einer Drehbewegung entgegensetzt. Der Benutzer erhält die haptische Rückmeldung eines Endanschlags.

Dabei kann eine Rasterung der Drehbewegung erfolgen bzw. erzeugt werden. Beispielsweise kann dies verwendet werden, um durch ein grafisches Menü zu navigieren und Menüpunkte auszuwählen. Hier ist direkt neben dem linken Endanschlag 228 ein erster Rasterpunkt 226 vorgesehen, der bei einer Bedienung z. B. einem ersten Menüpunkt entspricht. Soll der nächste Menüpunkt angewählt werden, so muss der Drehknopf 100 im Uhrzeigersinn gedreht werden. Dazu muss das dynamisch erzeugte höhere Magnetfeld bzw. Rastmoment 239 bzw. dessen Reibmoment überwunden werden, bevor der nächste Rasterpunkt 226 erreicht wird. In Figur 14a wird für einen gewissen Winkelbereich jeweils an den Rasterpunkten 226 und an den dazwischenliegenden Bereichen ein jeweils konstantes Magnetfeld erzeugt, welches an den Rasterpunkten erheblich geringer ist als in den dazwischenliegenden Bereichen und nochmals deutlich geringer als an den Anschlägen 228, 229.

Ein Winkelabstand 237 zwischen einzelnen Rasterpunkten ist dynamisch veränderbar und wird an die Anzahl der zur Verfügung stehenden Rasterpunkte bzw. Menüpunkte angepasst.

Figur 14b zeigt eine Variante, bei der zu den Endanschlägen 228, 229 hin das Magnetfeld nicht schlagartig ansteigt, sondern einen steilen Verlauf nimmt. Weiterhin sind an den Rasterpunkten 226 zu beiden Drehseiten hin jeweils rampenartige Steigungen des Magnetfeldes vorgesehen, wodurch der Drehwiderstand in die entsprechenden Drehrichtungen hin zunimmt. Hier werden mit der gleichen Eingabeeinrichtung 502 nur drei Rasterpunkte 226 zur Verfügung gestellt, deren Winkelabstand 237 größer ist als in dem Beispiel gemäß Figur 14a.

Figur 14c zeigt eine Variante, bei der zwischen einzelnen Rasterpunkten 226 ein geringerer Drehwiderstand vorliegt und nur direkt benachbart zu den Rasterpunkten 226 jeweils ein erhöhtes Magnetfeld 239 erzeugt wird, um ein Einrasten an den einzelnen Rasterpunkten 226 zu ermöglichen und gleichzeitig nur einen geringen Drehwiderstand zwischen einzelnen Rasterpunkten zur Verfügung zu stellen.

Grundsätzlich ist auch eine Mischung der Betriebsweisen und der Magnetfeldverläufe der Figuren 14a, 14b und 14c möglich. Z. B. kann bei unterschiedlichen Untermenüs eine entsprechend unterschiedliche Einstellung des Magnetfeldverlaufes erfolgen.

Figur 14d zeigt die mögliche Verwendung beim Annehmen z. B. eines Telefongesprächs. Das Bedienelement 503 der Eingabeeinrichtung 502 kann mit geringem Widerstand z. B. minimal - oder praktisch gar nicht - gedreht werden. Anschließend steigt das benötigte Drehmoment steil oder auch schlagartig bis zur Schwelle 230 an. Nach dem Überwinder der Schwelle 230 wird z. B. ein eingehendes Telefongespräch oder eine Videokonferenz angenommen. Der Drehwiderstand sinkt bis auf ein relatives minimales Moment 231 ab. Sofort danach wird hier die Funktion des Bedienelements 503 geändert. Beim Weiterdrehen wird z. B. die Lautstärke des Gesprächs verändert. Hier wird linear das benötigte Drehmoment gemäß der Steigung 232 erhöht. Möglich ist es auch, dass der Verlauf nicht linear ist. Möglich ist es auch, dass ab einer gewissen Lautstärke eine stärkere Steigung eingestellt oder das benötigte Moment schlagartig ein gewisses Maß erhöht wird.

Möglich ist es in allen Fällen auch, dass bei z. B. einem Ripple (Raster) nicht wie bislang zwischen wenig und mehr Stromstärke mit gleicher Polung geschaltet wird (also z. B. +0,2 auf +0,8A = Rippel), sondern abwechslungsweise mit verändertet Polung, d. h. von +0,2 auf +0,8A und dann den nächsten Rippel mit -0,2A auf - 0,8A und dann die nächste Momentenspitze von +0,2 auf +0,8A usw. Der vorzugsweise niederlegierte Stahl kann ein Restmagnetfeld behalten. Der Stahl wird vorzugsweise regelmäßig oder bei Bedarf entmagnetisiert (u.a. durch ein spezielles Wechselfeld).

Bevorzugt wird für die vom Magnetfeld durchflossenen Komponenten der Werkstoff FeSi3P (Siliziumstahl bzw. Silicon Steel) oder ein artverwandter Werkstoffe verwendet.

In allen Fällen kann eine Sprach- oder Geräuschsteuerung durchgeführt werden. Mit der Sprachsteuerung kann die Bremseinrichtung adaptiv gesteuert werden.

Wenn die Dreheinheit nicht gedreht wird, d. h. der Winkel ist konstant, wird vorzugsweise über die Zeit der Strom kontinuierlich verringert. Der Strom kann auch geschwindigkeitsabhängig (Drehwinkelgeschwindigkeit der Dreheinheit) variiert werden.

Bei der Erfindung wird beispielsweise als Bedienelement ein haptischer Drehknopf bzw. eine Daumenwalze oder auch eine Drucktaste mit haptischer Rückmeldung in eine (Smartphone-) Hülle (Hüllenteil) verbaut.

### Anwendungsmöglichkeiten z. B.:

- Verstellen der Lautstärke während dem Telefonieren: Je lauter eingestellt wird, desto mehr Drehmoment wird am Bedienelement benötigt. Ein Anschlag wird erzeugt (ganz hohes Drehmoment), wenn die Lautstärke nicht mehr erhöht werden kann bzw. eine kritische Lautstärke erreicht wird.
- Zoomen beim Fotografieren ohne die Finger ins Display zu bewegen: Solange das optische Zoom verstellt wird, bringt die Bremse ein bestimmtes Drehmoment (z.B. Drehmomentzunahme mit zunehmender Brennweite) auf. Wenn vom optischen Zoom in den digitalen Zoombereich übergegangen wird, fühlt der Benutzer Zuerst ein kurzer Anschlag (hohes Drehmoment) und dann ein Raster/Rippel. Der Nutzer merkt so, dass er sich im Bereich des digitalen Zooms befindet. Vorteilhaft und bevorzugt ist auch, dass die Bewegbarkeit bzw. das Feed Back des Eingabeelements in Abhängigkeit eines Zoomvorgangs eingestellt wird. Insbesondere wird für ein Heranzoomen eine anderes Drehmoment als für ein Herauszoomen eingestellt. Beispielsweise erfolgt für das Heranzoomen einer höheres Drehmoment als für das Herauszoomen oder umgekehrt. Dasselbe gilt, wenn die Verwacklungsneigung größer wird z.B. mit zunehmender Brennweite. Sobald der Nutzer der Verwackelungsgefahr unterliegt, wird dies haptisch am Bedienelement gemeldet. Wobei sich dieser (Verwackelungs-)bereich dynamisch verändert, je nach Situation (Lichtverhältnissen wegen Verschlusszeit...). Bei einem Zweizonenbedienelement nach z.B. Figur 3 kann mit der einen Zone das Zoom (die Brennweite) grob bzw. in großen Brennweitenschritten, denen ein entsprechend grober Raster (Drehmomente am Bedienelement) zugeordnet ist, eingestellt werden, mit dem anderen eine Feineinstellung vorgenommen werden. So ist ein schnelles, präzises und sicheres Einstellen möglich.
- Statt dem Zoom (Brennweite) kann auch die Verschlusszeit wie zuvor beschrieben eingestellt werden. Oder mit der einen Betätigungszone die Brennweite, mit der anderen die Verschlusszeit. Wobei ein klares haptisches Feedback erfolgt, wenn Verwackelungsgefahr besteht oder andere Situationen entstehen, die die Aufnahmequalität verschlechtern würden.
- Verstellen der Musiklautstärke: Kurzee Barriere/kurzer Anschlag bei bevorzugter Lautstärke. Wenn die Musik zu laut wird, lässt sich das Bedienelement schwergängig drehen. Wird die Musik so laut, dass die Umgebung gestört wird, erhält der Benutzer eine haptische Rückmeldung. Diese ist wiederum dynamisch an die Situation angepasst. In leiser Umgebung (z.B. Büro) ist die Rückmeldungsschwelle niedriger als in einer lauten Umgebung (z.B. U-Bahn; Zug; Flugzeug). Die Bildschirmhelligkeit lässt sich auch über das Bedienelement verstellen (z.B. wenn das Umgebungslicht zu hell ist und man nichts auf dem Bildschirm erkennen kann und dadurch auch nicht sieht, was man verstellt).
- Durchblättern von Telefonbuch, Liederliste (Wiedergabeliste), Dateien etc.
- Scrollen - durch Internetseiten, Dateien etc.
- Das Bedienelement kann auch bedient werden, wenn Handschuhe oder Pflaster getragen werden, da ein mechanisches Drehen erfolgt, und nicht die Berührungen der Haut erfasst werden, wie bei einem berührungssensitiven Bildschirm!
- Die Rasterweite kann der Benutzer beliebig einstellen.
- Kindersicherung: Das Drehmoment des Bedienelementes zum Bedienen kann so stark erhöht werden, dass z.B. ein Kind/Jugendlicher dieses mangels muskelbedingter geringerer Tangentialkraft nicht drehen und somit das Gerät nicht bedienen, vorzugsweise nicht einschalten, kann.

### Modularer Aufbau:

Eine Smartphonehülle kann der Benutzer für sein Smartphone einfach nachrüsten.Das beschriebene Bedienelement kann aber auch direkt im Smartphone integriert sein oder in einem Smart Device.

Die Hülle kann zusätzlich einen Akku enthalten, um die Laufzeit des Geräts zu erhöhen. Es ist aber nicht zwingend notwendig.

Der Vorteil eines zusätzlich verbauten Akkus wäre, dass der haptische Drehknopf (die Daumenwalze) direkt aus diesem Akku den Strom beziehen und über die dann sowieso vorhandene Stromleitung (Stromübertragung vom Zusatzakku an den Smart Device) auch mit dem Smartphone kommunizieren kann. Die Verbindung zum Smartphone kann entweder über einen Stecker in die Lade- bzw. allgemeine Anschlussbuchse erfolgen, oder via Bluetooth, NFC, Infrarot oder sonstige drahtloses Datenübertragungsart.

Die Batterie in der Hülle kann entweder klassisch mit Kabel geladen werden, oder mittels induktivem Laden. Es kann auch die Batterie des Smartphones induktiv von der Batterie der Hülle geladen werden.

### Reduktion der Bedienknöpfe

### • Bedienhilfe Smartphones und anderen Smartdevices ohne oder mit wenigen Bedienknöpfen (z.B. Smartphone das nur über Touchscreen bedient werden kann)

Gerade moderne Smartphones haben die Anzahl an Druckknöpfen extrem reduziert. Es wird meist alles nur noch über das Display bedient. Manche Optionen sind jedoch nicht über das Display einstellbar, z.B. Lautstärkeverstellung (speziell während dem Telefonieren, wenn das Telefon am Ohr ist). Beim Fotografieren mit dem Smartphone ist es auch nicht optimal über den Bildschirm die Kamera auszulösen, da man dabei verwackeln kann und das Smartphone nicht stabil in der Hand/beiden Händen hält.

Viele Smartphonehersteller versuchen, soviel wie möglich Knöpfe/Tasten etc. einzusparen, aus Designgründen, aber auch um z.B. das Gerät wasserdicht zu machen. Je weniger bewegliche Teile, desto weniger Möglichkeiten, dass Verschmutzungen und Wasser etc. ins Innere eindringen können. Bedientasten und Drehräder in der Hülle, also sowieso außerhalb des Smartphones umgehen dieses Problem. Wenn ein Benutzer nicht so viel Wert auf Design legt, aber auf größere Flexibilität und auch Benutzerfreundlichkeit, stellt eine solche Hülle eine gute Möglichkeit dar, das Telefon zu verbessern bzw. auf die eigenen Ansprüche anzupassen, ohne dass ein komplett neues Gerät gekauft werden muss. Viele Benutzer wollen ihr Smartphone mit einer zusätzlichen Hülle schützen, da liegt es nahe, die Hülle gleich mit zusätzlichen Funktionen auszustatten. So muss der Benutzer nicht auf z.B. einen Drehknopf am Rand verzichten.

Die Hülle kann über einen Stecker an das Smartphone geschlossen werden (in der Steckerbuchse für das Ladekabel) oder mit drahtloser Datenübertragung verbunden.

Es ist im Prinzip wie eine konventionelle Schutzhülle für Smartphones, welche noch zusätzlich externen Telefonperipherie enthält.

In der Fig. 1 sind mögliche Einbauformen des Bedienelements (hier eines Drehknopfes bzw. einer Daumen-/Fingerwalze) in dem Hüllenteil (Hülle) gezeigt. In der Figur 2 ist eine erfindungsgemäße Hülleneinrichtung für ein Smartphone gezeigt, bei dem das Bedienelement seitlich angeordnet ist. Zudem ist in den Hüllenteil ein Akku integriert.

### Reduktion der Teilevielfalt / Gleichteile:

Die Kombination Touchdisplay (Anzeige) plus haptischer Knopf kann bei verschiedenen Anwendungen eingesetzt werden. Die gleiche Basiskonfiguration (Hardware) kann durch verschiedene Software "angepasst" werden. Z.B. Lautstärkeregelung, Scrollen durch Telefonbuch, etc...

### Kosten

Eine Bremseinrichtung wie in der DE 10 2018 100 390 A1 gezeigt (sog. Keillager) kann kostengünstig hergestellt werden. Es hat wenig und einfache Teile aus Standardmaterial und erzielt aufgrund vom Keileffekt ein sehr hohes Moment, bezogen auf die Baugröße. Zudem ist der Stromverbrauch (Leistungsbedarf) auch sehr gering. Eine MRF-Bremse könnte deshalb einfach über den Akku des Smartphones bzw. direkt vom Smart-Battery-Case mit Strom versorgt werden.

### Modularität - Linkshänder-Smartphone

Eine erfindungsgemäße Hülleneinrichtung (Hülle) kann relativ einfach im Aufbau verändert werden. Die Position des haptischen Bedienknopfs bzw. der Daumenwalze kann ohne viel Veränderung des Designs auf die andere Seite (von rechts nach links) gebracht werden. In einem Smartphone ist das nicht so einfach, weil die gesamte innere Architektur verändert werden muss. Die Leiterbahnen etc. müssen anders verlaufen. Eine Hülle hat nicht so viele Komponenten, auf die geachtet werden muss. Zusätzlich kann die Kommunikation zwischen Smartphone und Daumenwalze über Bluetooth erfolgen. Das Bluetoothmodul kann direkt bei der Daumenwalze verbaut sein. D.h. es muss nur ein Stromanschluss an die Batterie erfolgen.

Man kann dadurch relativ günstig zwei verschiedene Hüllen für Rechts- und Linkshänder herstellen. Oder auch noch mehr unterschiedliche Hüllen, bei denen die Position des Knopfes variiert, je nach dem wozu der Knopf primär verwendet wird (zum Fotografieren, Lautstärke während dem Telefonat verändern; mit Zeigefinger oder mit Daumen bedienen etc.)

Die Hülle könnte auch so modular hergestellt werden, dass das Keillager in verschiedene Stellen eingesetzt werden kann. Es werden in der Hülle verschiedene Öffnungen vorgesehen, die die nötigen Anschlüsse für Stromversorgung und Datenübertragung haben. Das Keillager kann dann aus der Öffnung/Halterung heraus genommen werden und in eine andere eingesetzt werden. So kann von Rechts- in Linkshändermodus umgebaut werden. Oder der Knopf wird von unten in den Oberen Bereich des Smartphones gelegt.

### Haptischer Drehknopf mit verschiedenen Zonen

Ein Drehknopf kann mehrere Betätigungszonen (Zonen) aufweisen, die z.B. verschiedene Oberflächen aufweisen (in verschiedene Richtungen geriffelt, ganz glatt, grob oder fein), z.B. in drei Zonen. Der Knopf hat aber nur eine Steuerung, ein Sensor und eine Dämpfeinrichtung, aber die haptische Rückmeldung kann eine andere sein, je nachdem an welcher Stelle man ihn betätigt/berührt.

Somit weiß der Nutzer, dass er jetzt was anderes verstellt. Sensoren erkennen, wo man ihn betätigt/berührt. Wenn ein Benutzer einen Finger zum Drehknopf bewegt, erkennen die Sensoren, zu welchem Bereich man den Finger hinführt, und aktiviert dann die dazugehörige Funktion.

So können mit dem gleichen Drehknopf verschiedene Funktionen gesteuert werden, ohne dass man etwas zuvor umstellen oder auswählen muss.

In der Figur 3 ist eine erfindungsgemäße Hülleneinrichtung mit zwei Betätigungszonen in verschiedenen Ansichten gezeigt.

In der Figur 4 ist eine erfindungsgemäße Hülleneinrichtung mit drei Betätigungszonen in verschiedenen Ansichten gezeigt.

In der Figur 5 ist eine erfindungsgemäße Hülleneinrichtung mit zwei Betätigungszonen (links) und drei Betätigungszonen (rechts) Betätigungszonen und den entsprechenden Sensoren gezeigt.

Beispiel:
Der Drehknopf weist zwei Zonen auf: Mit der einen Zone stellt man die Lautstärke der Medienwidergabe ein (zunehmendes Drehmoment bei zunehmender Lautstärke), mit der zweiten Zone wählt man das Lied (Vor/Zurück - also ein haptische Rastfunktion. Bei Lieblingslieder: härterer Raster bzw. höheres Bremsmoment). Oder die zweite Zone hat eine ganz andere Funktion (Zoom der Kamera).

Als Sensoren können verschiedene Techniken verwendet werden. Zum Beispiel einen Näherungssensor in der Nähe des jeweiligen Bereichs, oder kapazitive Sensoren auf der Daumenwalze, induktive Sensoren, die Kamera (Bilderkennung) vom Smartdevice etc. Die Sensoren können neben der Walze oder auf der Walze angebracht sein.

Die Anzahl der Zonen können beliebig sein (1,2,3...), aber eine bevorzugte Zahl ist wahrscheinlich 3. Der MRF Dämpfer ist in einer der Zonen angebracht, die anderen Zonen sind drehfest mit dieser Zone verbunden. Die Zonen können mit unterschiedlichen Oberflächen ausgestattet sein (die Oberflächen müssen nicht zwingend verschieden sein, es lässt sich aber so intuitiver bedienen).

Wie erwähnt, kann die haptische Rückmeldung in den verschiedenen Zonen unterschiedlich sein. Es können verschiedene Rippel mit unterschiedlichen Abständen der Widerstandsbarrieren sein, der Widerstand kann bei den Zonen konstant sein, mit verschiedener Stärke etc. Da alle Zonen mit der gleichen MRF-Bremseinheit gebremst werden, drehen sich natürlich alle Zonen immer gleichzeitig, aber die Steuerung merkt durch die Sensoren, welche Zone betätigt wird, und steuert mittels Software dann die richtige Funktion (es wird also nicht gleichzeitig die Lautstärke geregelt und der Zoom der Kamera verändert). Der Sensor für die Bestimmung der Position des Fingers ist natürlich nur dafür, es benötigt immer noch einen zusätzlichen Sensor zur Messung der Drehung der Daumenwalze.

Der große Vorteil dieser Art der Verwendung von einem Knopf mit verschiedenen Zonen ist, dass nur eine Steuerung und auch nur ein Dämpfer verwendet werden muss, um mehrere Funktionen steuern zu können.

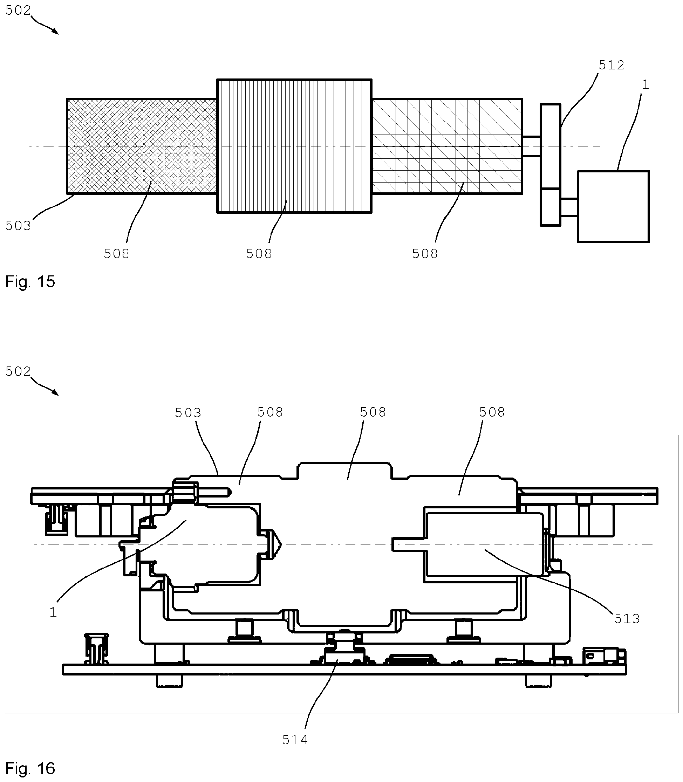

Die Fig. 15 zeigt ausschnittsweise eine Eingabeeinrichtung 502, wie sie beispielsweise zuvor beschrieben wurde. Dabei ist die Bremseinrichtung 1 hier über eine Getriebeeinheit 512 an das Bedienelement 503 gekoppelt ist. Dadurch kann ein höheres (Brems-) Moment erzielt werden. Zudem überbrückt die Getriebeeinheit 512 die hier parallel versetzt angeordneten Drehachsen (strichpunktiert skizziert) von Bedienelement 503 und Bremseinrichtung 1.

In der Fig. 16 ist eine Eingabeeinrichtung 502 gezeigt, bei welcher das Bedienelement 503 ergänzend zum manuellen Drehen auch mit einer Antriebseinrichtung 513 aktiv gedreht werden kann. Eine solcher aktiver Antrieb kann für alle hier beschriebenen Eingabeeinrichtungen 502 vorteilhaft eingesetzt werden. Die Antriebseinrichtung 513 ist hier gegenüber von der Bremseinrichtung 1 angeordnet und weist die gleiche Drehachse (strichpunktiert skizziert) wie das Bedienelement 503 und die Bremseinrichtung 1 auf. Das ermöglicht eine besonders kompakte Unterbringung.

Gut zu erkennen ist hier eine Schalteinheit 514, welche durch Drücken des Bedienelements 503 betätigt werden kann. Die Schalteinheit 514 ist hier mit einem Drucksensor ausgestattet. Dadurch kann in Abhängigkeit davon eine Eingabe erfolgen, wie stark auf das Bedienelement 503 gedrückt wird. Die Schalteinheit 514 kann auch als ein Schalter ohne Drucksensor ausgeführt sein.

In allen Ausführungsbeispielen und Ausgestaltungen ist es auch möglich, dass die Bremseinrichtung motorisch ausgebildet ist. Beispielsweise kann ein Elektromotor gezielt bestromt werden, um ein gewünschtes Bremsmoment zu erzeugen.

### Mögliche haptische Rückmeldungen

Mit schnell schaltbaren MRF-Dämpfern können mechanische Geräte simuliert werden. z.B. einen Drehknopf eines alten Radios. Der Knopf wird zum Einschalten des Radios zuerst gegen einen hohen Widerstand gedreht, bis dieser überwunden ist. Dann ist der Radio eingeschaltet und die Lautstärke kann durch weiteres Drehen eingestellt werden.

Mit der Daumenwalze kann auch beim Betätigen zuerst ein hoher Widerstand eingestellt werden, bis ein kleiner Winkelbereich gedreht wird. Dann wird der Widerstand wieder auf den Minimalwert eingestellt und der Widerstand langsam mit dem Drehwinkel erhöht, je höher die Lautstärke wird (vgl. Fig. 6). So kann z.B. auch der Mediaplayer des Smartphones eingeschalten werden, und dann gleich die Lautstärke dazu eingestellt.

Das Abnehmen eines Anrufes geht meist einher mit der Justierung der Lautstärke (je nach Verbindungsqualität, Umgebungsgeräusch usw. muss die Lautstärke angepasst werden). Über den Drehknopf kann beides gut, einfach und schnell ausgeführt werden. Ein unbeabsichtigtes Abnehmen kommt so auch weniger oft vor.

Das Konzept mit einem haptischen Drehknopf in der Hülle kann auch auf Tablets bzw. alle Arten von portablen Smart Devices umgesetzt werden, bei denen im Gerät selbst wenige oder keine Knöpfe verbaut werden.

### Pinch to Zoom

Pinch to Zoom beschreibt die Möglichkeit mit zwei Fingern zu zoomen, indem sie auseinander bzw. zusammen gezogen werden. Bei Smartphones ist diese Art von zoomen bei einhändiger Bedienung nicht oder nur schwer möglich. Ein Drehknopf der mit z.B. dem Daumen oder auf der anderen Seite mit dem Zeigefinger bedient werden kann, könnte die einhändige Bedienung bei z.B. zoomen ermöglichen.

### Bedienung mit Handschuh (Winter, kalt, Hygiene...)

Smartwatches verfügen zumeist über ein kapazitives Display, welches sich kaum bzw. je nach Hersteller gar nicht mit Handschuhen bedienen lässt. Ein haptischer Schalter hat hier klare Vorteile. Bei der Benutzung des Smartphones akzeptiert man das Ausziehen des Handschuhes noch eher, da dieses aus einer Tasche gezogen werden muss (also längerer Vorgang). Der Sinn einer Smartwatch ist aber der schnelle Zugang zu Infos. Aus hygienischen Gründen (Infektion; Virus) müssen Handschuhe angelassen werden, was eine Bedienung von Smart Devicen mit Touchscreen schwer bis unmöglich machen.

### Scrollen fälschlicherweise als Drücken erkennen

Durch das kleine Display wird des Öfteren Scrollen fälschlicherweise als Drücken erkannt. Mit einem Drehrad kann das nicht passieren.

### Intelligentes Lesen:

Zoomt auf gut lesbare Größe und dann beim Drehen immer genauso, wie der Mensch auch eine Textstelle lesen würde. D.h. er springt am Ende des Satzes an den Anfang zurück usw. Dabei bleibt Schrift immer auf gleicher Höhe (im gleichen Lesebereich), damit das Auge nicht hin- und her springen muss.

### Anrufe Annehmen bzw. Ablehnen

Bei einem Anruf wird je nach Drehrichtung um einen gewissen Winkel mit Anschlag der Anruf angenommen bzw. abgelehnt (z. B. im Uhrzeigersinn: Abnehmen. Gegen Uhrzeigersinn: Ablehnen / nicht annehmen). Beim Ablehnen kann man durch Drehen des Knopfes durch vordefinierte Nachrichten (Rückmeldungen) gescrollt werden und durch Knopfdruck an den Anrufer gesendet werden (z.B. Bin gerade in einem Meeting).

### Sehbehinderung (evtl. in Kombination mit Hörbehinderung)

Menschen mit Sehbehinderung (Blinde) können durch ein entsprechendes Feedback, z.B. in Form von einem Morsecode, Hilfestellung erfahren.

### Display defekt / SOS / Notruf:

Bei einem defektem Display kann immer noch eine Basisbedienung gewählt werden, wenn das Bedienelement wie zu Figur 6 beschrieben verwendet wird. Es können auch noch verschiedene Personen oder Funktionen durch Drehen mit Raster/Rippel gewählt werden, wenn die Namen / Funktionen durch den Lautsprecher wiedergeben werden.

Eine SOS Betätigung (kurz/lang/kurz) des Bedienelementes kann detektiert und entsprechende Funktionen ausgeführt werden.

### Stromsparen:

Die zuvor beschriebene "Display defekt" Funktion kann auch eingesetzt werden, wenn der Akku zur Neige geht, also Strom/Energie gespart werden soll. Das Display kann in einer ersten Stufe stark gedimmt werden, da das Abnehmen, das Regeln der Lautstärke und das Auflegen über das adaptive Bedienelement bediensicher ausgeführt werden können. Über den Zweizonenregler (nach z.B. Figur 3) kann die Displayhelligkeit rasch und bediensicher angepasst werden, wenn mehr Helligkeit benötigt wird. In einer zweiten Energiesparstufe kann das energieverbrauchsintensive Display ganz abgeschaltet werden.

### Verschiedene Kameras auswählen

In neuen Smartphones werden eine immer größer werdende Zahl an Kameras verbaut. Normal ist schon eine auf der Rückseite und eine Selfikamera auf der Vorderseite. Es kommen aber auch immer öfter noch zusätzliche Kameras wie z.B. Weitwinkelkamera, oder in Zukunft auch Teleobjektive dazu. Mit der Daumenwalze kann der optische Zoom bedient werden. Und es kann einfach und schnell zwischen den Kameras mit der Daumenwalze hin- und her gewechselt werden. Mit der zuvor beschriebenen Ausführung mit mehreren Zonen können mehrere Kameras geleichzeitig verstellt/bedient werden.

### Daumenwalze beispielhafter Aufbau

Die Daumenwalze ist vorzugsweise ein liegendes Keillager, welches sehr schmal ausgeführt wird. Die Wälzkörper sind auch in diesem Fall zylinderförmige Walzen, aber mit kleinem Durchmesser (z.B. 1mm) und größerer axialer Ausdehnung (z.B. 5mm). Die Magnetspule kann entweder liegend (in axiale Richtung gewickelt) oder in radiale Richtung (Spule um die Achse gewickelt) ausgeführt werden.

Wie bei allen anderen Aktoren für haptisches Feedback braucht auch die Daumenwalze einen Sensor, der die Drehung misst. Dazu kann ein Drehgeber oder auch ein Magnetring mit Hallsensor verwendet werden. Es können mit der Daumenwalze prinzipiell die selben haptischen Rückmeldungen implementiert werden, wie mit jedem anderen Drehknopf mit Keillager. Durch seinen kleinen Bauraum können nicht so hohe Drehmomente erzeugt werden. Das ist aber durch den kleinen Durchmesser auch gar nicht nötig.

Die DE 10 2018 100 390 A1 und die WO 2019/138015 beschreiben Daumenwalzen mit einer axialen Spule und ermöglichen besonders schmale Aktoren.

### Einbaumöglichkeiten

Die Walze kann in der Smartphonehülle entweder mit axialer Richtung parallel zum Smartphone eingebaut werden, oder um 90° gedreht. Je nachdem mit welchen Fingern hauptsächlich gedreht wird, kann die jeweilige Art besser sein. Für zweitere ist jedoch ein normaler Knopf mit Keillager besser geeignet, da dieser kürzer aber dafür in radialer Richtung größer gebaut werden kann.

### Push

Die Daumenwalze kann auch eine Pushfunktion haben (die Daumenwalze wird hierbei gedrückt). Dies kann zum Bestätigen einer Funktion, zum Schalten (Ein/Aus), als Return oder auch jede andere Funktion (z.B. vom Kunden definiert - wie z.B. das Abnehmen oder Auflegen des Anrufes) sein. Die Pushfunktion kann auch mehrstufig (adaptiv) sein.

### Adaptives Scharnier in faltbaren Smartphones

Es gibt schon erste faltbare Smartphones auf dem Markt. Diese Smartphones sind zusammengefaltet so groß, wie ein normales Smartphone, und auseinandergefaltet dementsprechend doppelt so groß. Die einhändige Bedienung wird dadurch noch einmal schwieriger, weshalb ein Drehrad hier Vorteile hätte (Zoomen, Abnehmen...). Zum einen sind die Bildschirme viel zu groß, um die gesamte Fläche zu erreichen, andererseits kann das Smartphone versehentlich zusammengefaltet werden.

Dem kann abgeholfen werden, indem eine Hülle mit Daumenwalzen als Scharniere ausgestattet wird (vgl. Fig. 7 und Fig. 8). Wenn das Smartphone aufgeklappt wird, sperren die Daumenwalzen im geöffneten Zustand und das Smartphone lässt sich nicht so leicht zusammenklappen. Auch in diesem Fall können die Daumenwalzen aus einem zusätzlichen Akku aus der Hülle gespeist werden.

Die Daumenwalze muss aus Gründen der Kinematik dabei genau im Drehpunkt gelagert sein. Das ist schwierig, da sich das Smartphone bzw. das Display dort befindet. Man kann also entweder die Daumenwalze direkt ins Smartphone verbauen, oder muss mit speziellen linear verfahrbaren Scharnieren arbeiten. Natürlich kann auch in diese Art von Hülle auch ein haptischer Bedienknopf am Rand wie davor beschrieben eingebaut werden.

### Touch-Pad Hülle mit adaptiven Scharnieren

Die klappbaren Hüllen von Tablets bzw. Touch-Pads können auch mit solchen Scharnieren ausgestattet werden, damit die Hülle in jeder beliebigen Position gehalten werden können.

### Adaptive Scharniere für Laptops

Der Bildschirm eines Laptops kann einfach mit Daumenwalzen gebremst werden, da der Bildschirm im Drehpunkt befestigt wird. Beim Bewegen des Bildschirm können die Daumenwalzen auf niedrigsten Widerstand stellen, bei erreichen der gewünschten Position wird der Widerstand auf maximalen Wert eingestellt.

### Lesehilfe für Bücher

Die Idee als Scharniere für Hüllen von Smartphones und Tablets etc. kann auch mit normale "analoge" Bücher verwendet werden. Man macht einen einfachen Rahmen, der in das Buch zwischen die Seiten geschoben wird, mit einem Scharnier mit Daumenwalzen als Dämpfer. Der Rahmen hält dann das Buch aufgeklappt und der Leser kann das Buch angenehmer halten.

### Adaptive Funktionswahl

Je nach gewählter Funktion ändert sich die Tastenbelegung. Wird die Kamera als zu bedienendes Element gewählt, erhält die Taste die Zoomfunktion oder die Funktion, die der Nutzer am meisten wählt. Der Kunde kann dies dann selber voreinstellen oder der Device wählt dies aufgrund einer internen Nutzerdatenauswertung selber. Hier kann auch die Künstliche Intelligenz bzw. Maschinenlernen die Benutzerführung verbessern und die Bedienkomplexität verringern.

Die Erfindung betrifft insbesondere eine Vorrichtung mit dem haptischen Drehknopf/Daumenwalze in einer Hülle für Smartphones; die Daumenwalze ermöglicht Bedienung des Smartphones für verschiedene Apps, sie wird von dem Smartphone gesteuert; die haptischen Rückmeldungen sind z.B. Erhöhung des Widerstands beim Drehen; Verwendung von Sensoren zur Messung der Drehbewegung schränken uns nicht ein.

Die Erfindung sieht insbesondere eine Verwendung von MRF im Aktor vor.

Die Erfindung sieht insbesondere eine Kommunikation zwischen haptischem Drehknopf und Smartphone über Stecker oder Drahtloser Übertragung, wie z.B. Bluetooth, NFC, Infrarot etc. vor.

Die Erfindung sieht insbesondere eine Verwendung eines zusätzlichen Akkus in der Hülle vor, um den Aktor zu betreiben.

Der MRF-Aktor ist insbesondere als Keillager mit Wälzkörper mit radialer oder axialer Spule ausgeführt.

Die Erfindung sieht insbesondere einen modularen Aufbau vor. Das gibt die Möglichkeit, die Position des Aktors zu verändern.

Das haptische Feedback kann auch akustisch (durch einen Lautsprecher) oder visuell (Lampe, LED, Anzeige im Display, Beleuchtung des Bedienelementes...) untermauert werden.

Die hier vorgestellte Erfindung kann auf verschiedenen technischen Gebieten eingesetzt werden, beispielsweise Smartphone, Smartwatch bzw. Smartdevices, Tablets (Touch), kleine Anzeigen, Android Application (Apps), Apple (iOS) Application (Apps), Fotografie, Hülle für Fotoapparate, Fernbedienungen, Office PC, Gaming (Computermaus, Tastatur, Controller), Computermaus, Hi-Fi oder Fernsehanlagen.

### Bezugszeichenliste:

| | | | |
|---|---|---|---|
| 1 | Magnetorheologische | 27 | Steuereinrichtung |
| | Bremseinrichtung | 28 | Vergussmasse |
| 2 | Bremskomponente | 30 | Lager |
| 3 | Bremskomponente | 32 | Quernut |
| 4 | Halter | 33 | Grundkörper |
| 5 | Spalt, Kanal | 35 | Kabeldurchführung |
| 5a | Spaltbreite | 36 | Aufnahme |
| 6 | Medium | 36a | Außendurchmesser |
| 8 | Feld | 37 | zylindrische Lauffläche |
| 9 | freier Abstand | 37a | Außendurchmesser |
| 10 | spitzwinkliger Bereich | 38 | Dichtung |
| 11 | Übertragungskomponente, Wälzkörper, Drehkörper | 43 | Benutzerschnittstelle |
| | | 45 | Kabel |
| 11d | Arm | 46 | Dichtring |
| 12 | Drehachse | 48 | Gleitführung |
| 13 | Drehteil, | 49 | Überzug |
| 13a | Innendurchmesser | 50 | Konsole |
| 13b | Außendurchmesser | 61 | Winkelsegment |
| 13c | Höhe | 62 | Winkelsegment |
| 13d | Wandstärke | 63 | Aufnahme für 11 |
| 13e | Hülsenteil (1x Zeichnung) | 64 | Außenoberfläche |
| 14 | Kugel | 65 | radiales Spaltmaß |
| 15 | Zylinder | 66 | radialer Abstand |
| 16 | Keilform | 67 | Innenoberfläche von 13 |
| 17 | Richtung der Relativbewegung | 68 | Signal |
| | | 69 | Amplitude |
| 18 | Richtung der Relativbewegung | 70 | Sensoreinrichtung |
| | | 71 | Magnetringeinheit |
| 19 | magnetische Partikel | 72 | Magnetfeldsensor |
| 20 | axiale Richtung | 73 | Sensorleitung |
| 21 | Kern | 74 | Taster |
| 21b | minimaler Durchmesser | 75 | Abschirmeinrichtung |
| 23 | Drehknopf | 76 | Abschirmkörper |
| 24 | Außenring | 77 | Trenneinheit |
| 25 | radiale Richtung | 78 | Entkopplungseinrichtung |
| 26 | Spule | 110 | geschlossene Kammer |
| 26a | maximaler Durchmesser | 111 | erstes Ende von 110 |
| 26c | Spulenebene | 112 | erste Lagerstelle |
| 26d | radiale Richtung zu 26c | 113 | Magnetfelderzeug¬ungs- |
| | einrichtung | 528 | Sensor |
| 114 | Volumen von 110 | 530 | Geräteteile |
| 115 | zweites Ende der geschlossenen Kammer | 540 | Energiespeicher |
| 116 | Durchmesser erste Lagerstelle | | |
| 117 | Durchmesser zweite Lagerstelle | | |
| 118 | zweite Lagerstelle | | |
| 119 | Achsstummel | | |
| 120 | Ausgleichskanal | | |
| 121 | Endabschnitt von 2 | | |
| 122 | radiale Richtung (global) | | |
| 200 | Gerätekomponente | | |
| 226 | Rasterpunkt | | |
| 228 | Endanschlag | | |
| 229 | Endanschlag | | |
| 230 | Schwelle | | |
| 231 | minimales Moment | | |
| 232 | Steigung | | |
| 237 | Winkelabstand | | |
| 238 | Anschlagmoment | | |
| 239 | Rastermoment | | |
| 240 | Grundmoment | | |
| 500 | Hülleneinrichtung | | |
| 501 | Hüllenteil | | |
| 502 | Eingabeeinrichtung | | |
| 503 | Bedienelement | | |
| 505 | Sensoreinrichtung | | |
| 506 | Steuereinrichtung | | |
| 507 | Aufnahmeeinrichtung | | |
| 508 | Betätigungszone | | |
| 509 | Scharniereinrichtung | | |
| 510 | Mobilgerät | | |
| 511 | Hüllenabschnitt | | |
| 512 | Getriebeeinheit | | |
| 513 | Antriebseinrichtung | | |
| 514 | Schalteinheit | | |
| 518 | Überwachungseinrichtung | | |
| 520 | Gerätekörper | | |

## Patentansprüche

1. Hülleneinrichtung (500) für ein Mobilgerät (510), insbesondere Smartphone oder Tablet oder andere Arten von Handhelds bzw. mobilen Smart Devices, umfassend wenigstens ein Hüllenteil (501) zum wenigstens abschnittsweisen Umgeben des Mobilgeräts (510) und wenigstens eine wenigstens teilweise in dem Hüllenteil (501) angeordnete Eingabeeinrichtung (502) zur Ansteuerung des in dem Hüllenteil (501) aufnehmbaren Mobilgeräts (510), wobei die Eingabeeinrichtung (502) wenigstens ein bewegbares Bedienelement (503) und wenigstens eine Bremseinrichtung (1) umfasst und wobei eine Bewegung des Bedienelements (503) mittels der Bremseinrichtung (1) gezielt dämpfbar ist, **dadurch gekennzeichnet, dass** das Bedienelement (503) wenigstens zwei Betätigungszonen (508) umfasst und wobei die Bewegung des Bedienelements (503) in Abhängigkeit davon gezielt dämpfbar ist, in welcher Betätigungszone (508) das Bedienelement (503) betätigt und insbesondere berührt wird, und dass die Hülleneinrichtung (500) wenigstens eine Überwachungseinrichtung (518) umfasst, wobei die Überwachungseinrichtung (518) dazu geeignet und ausgelegt ist, sensorisch zu erfassen, in welcher Betätigungszone (508) die Betätigung erfolgt.

2. Hülleneinrichtung (500) nach dem vorhergehenden Anspruch, wobei die Bremseinrichtung (1) magnetorheologisch ausgebildet ist und wobei die Bremseinrichtung (1) wenigstens ein magnetorheologisches Medium (6) und wenigstens eine Felderzeugungseinrichtung (113) zur Erzeugung und Steuerung einer magnetischen und/oder elektrischen Feldstärke umfasst und wobei mittels der Felderzeugungseinrichtung (113) das Medium (6) beeinflussbar ist, um das Drehmoment für die Drehbarkeit des Bedienelements (903) einzustellen.

3. Hülleneinrichtung (500) nach einem der vorhergehenden Ansprüche, wobei eine Betätigungsstellung des Bedienelements (503) mittels wenigstens einer Sensoreinrichtung (505) erfassbar ist und wobei die Bremseinrichtung (1) mittels wenigstens einer Steuereinrichtung (506) wenigstens in Abhängigkeit der Betätigungsstellung des Bedienelements (503) ansteuerbar ist und wobei die Dämpfung in Abhängigkeit wenigstens eines mittels der Sensoreinrichtung (505) erfassten Drehwinkels des Bedienelements (503) einstellbar ist und insbesondere gezielt angepasst wird.

4. Hülleneinrichtung (500) nach einem der vorhergehenden Ansprüche, wobei wenigstens eine Steuereinrichtung (506) umfasst und dazu geeignet und ausgebildet ist, die Bremseinrichtung (1) wenigstens in Abhängigkeit wenigstens eines Steuerbefehls anzusteuern und den Steuerbefehl in wenigstens ein an dem Bedienelement (503) wahrnehmbares haptisches Signal, vorzugsweise eine definierte Abfolge von Verzögerungsmomenten, umzusetzen, sodass ein Benutzer wenigstens als Folge einer vorgenommenen Eingabe und/oder während einer Eingabe eine haptische Rückmeldung erhalten kann.

5. Hülleneinrichtung (500) nach einem der vorhergehenden Ansprüche, wobei die Eingabeeinrichtung (502) drahtlos und/oder drahtgebunden mit dem Mobilgerät (510) koppelbar ist, sodass das in dem Hüllenteil (501) aufgenommene Mobilgerät (510) durch die Eingabeeinrichtung (502) bedienbar ist und/oder sodass das Mobilgerät (510) Signale an die Eingabeeinrichtung (502) senden kann.

6. Hülleneinrichtung (500) nach einem der vorhergehenden Ansprüche, umfassend wenigstens ein Hüllenteil (501) mit einer für Rechtshänder optimierten Anordnung der Eingabeeinrichtung (502) und/oder umfassend wenigstens ein Hüllenteil (501) mit einer für Linkshänder optimierten Anordnung der Eingabeeinrichtung (502).

7. Hülleneinrichtung (500) nach einem der vorhergehenden Ansprüche, wobei das Hüllenteil (501) wenigstens zwei Aufnahmeeinrichtungen (507) zur Aufnahme jeweils wenigstens einer Eingabeeinrichtung (502) umfasst und wobei die Eingabeeinrichtung (502) wahlweise in eine der Aufnahmeeinrichtungen (507) einsetzbar ist.

8. Hülleneinrichtung (500) nach einem der vorhergehenden Ansprüche, wobei die Betätigungszonen (508) haptisch unterscheidbar sind und dazu insbesondere eine unterschiedliche Oberfläche und/oder Oberflächenstruktur und/oder Größe und/oder Geometrie und/oder Farbe und/oder Material aufweisen und/oder wobei eine haptische Rückmeldung in Abhängigkeit davon erfolgt, in welcher Betätigungszone (508) das Bedienelement (503) betätigt und insbesondere berührt wird.

9. Hülleneinrichtung (500) nach einem der vorhergehenden Ansprüche, wobei durch wenigstens eine erste Bewegung des Bedienelements (503) eine erste Eingabe ausführbar ist und wobei durch ein Weiterbewegen des Bedienelements (503) wenigstens eine weitere Eingabe ausführbar ist und wobei für die erste Bewegung eine andere Dämpfung als für das Weiterbewegen vorgesehen ist und/oder wobei nach der ersten Bewegung wenigstens eine gezielte Erhöhung des Verzögerungsmoments erfolgt, sodass zum Weiterbewegen ein zusätzlicher Kraftaufwand notwendig ist und wobei durch die erste Bewegung des Bedienelements (503) wenigstens eine Funktion gestartet wird und wobei durch das Weiterbewegen des Bedienelements (503) wenigstens eine Anpassung der Funktion erfolgt.

10. Hülleneinrichtung (500) nach einem der vorhergehenden Ansprüche, wobei die Steuereinrichtung (506) dazu geeignet und ausgebildet ist, wenigstens ein an dem Bedienelement (503) wahrnehmbares haptisches Signal bereitzustellen, welches als Hilfestellung für Menschen mit einer Beeinträchtigung dient.

11. Hülleneinrichtung (500) nach einem der vorhergehenden Ansprüche, wobei durch wenigstens ein Bewegen, insbesondere Drehen, des Bedienelements (503) ein Zoomen und/oder Scrollen und/oder eine Kameraauswahl und/oder eine Anrufsteuerung und/oder eine Menüauswahl ausführbar ist.

12. Hülleneinrichtung (500) nach einem der vorhergehenden Ansprüche, wobei durch wenigstens ein Bewegen, insbesondere Drehen, des Bedienelements (503) eine Hervorhebung eines Anzeigebereichs gezielt weiter geschoben werden kann und insbesondere wobei die Hervorhebung durch ein Drücken und/oder Drehen des Bedienelements (503) aktivierbar ist.

13. Hülleneinrichtung (500) nach einem der vorhergehenden Ansprüche, wobei das Hüllenteil (501) klappbar ausgebildet ist und wenigstens zwei Hüllenabschnitte (511) umfasst, welche durch wenigstens eine Scharniereinrichtung (509) bewegbar verbunden sind und wobei die Eingabeeinrichtung (502) in die Scharniereinrichtung (509) integriert ist.

14. Hülleneinrichtung (500) nach einem der vorhergehenden Ansprüche, wobei das Hüllenteil (501) klappbar ausgebildet ist und wenigstens zwei Hüllenabschnitte (511) umfasst, welche durch wenigstens eine Scharniereinrichtung (509) bewegbar verbunden sind, wobei die Scharniereinrichtung (509) mit wenigstens einer Bremseinrichtung (1) ausgestattet ist und wobei die Bremseinrichtung (1) dazu geeignet und ausgebildet ist, die Bewegung der Hüllenabschnitte (511) zueinander gezielt zu dämpfen und wobei die Bremseinrichtung (1) magnetorheologisch ausgebildet ist.

15. Mobilgerät (510), insbesondere Smartphone oder Tablet oder eine andere Art von Handheld bzw. mobilem Smart Device, umfassend wenigstens einen Gerätekörper (520) und wenigstens eine Eingabeeinrichtung (502) zur Ansteuerung von Gerätefunktionen,
wobei die Eingabeeinrichtung (502) wenigstens ein bewegbares Bedienelement (503) und wenigstens eine Bremseinrichtung (1) umfasst und wobei eine Bewegung des Bedienelements (503) mittels der Bremseinrichtung (1) gezielt dämpfbar ist, **dadurch gekennzeichnet, dass** die Eingabeeinrichtung (502) zu einem überwiegenden Teil innerhalb des Gerätekörpers (520) angeordnet ist, dass das Bedienelement (503) wenigstens zwei Betätigungszonen (508) umfasst, wobei die Bewegung des Bedienelements (503) in Abhängigkeit davon gezielt dämpfbar ist, in welcher Betätigungszone (508) das Bedienelement (503) betätigt und insbesondere berührt wird, und dass das Mobilgerät (510) wenigstens eine Überwachungseinrichtung (518) umfasst, wobei die Überwachungseinrichtung (518) dazu geeignet und ausgelegt ist, sensorisch zu erfassen, in welcher Betätigungszone (508) die Betätigung erfolgt.

## Claims

1. A sleeve device (500) for a mobile device (510), in particular a smartphone or tablet or other types of handhelds respectively mobile smart devices, comprising at least one sleeve part (501) for at least partially surrounding the mobile device (510) and at least one input device (502) at least partially disposed in the sleeve part (501) for actuating the mobile device (510) which can be accommodated in the sleeve part (501), wherein the input device (502) comprises at least one movable operating member (503) and at least one braking device (1), and wherein movement of the operating member (503) can in particular be damped controlled by means of the braking device (1),
**characterized in**
**that** the operating member (503) comprises at least two actuating zones (508), and wherein the movement of the operating member (503) can be damped controlled in dependence on the actuating zone (508) in which the operating member (503) is actuated and in particular touched, and that the sleeve device (500) comprises at least one monitoring device (518), wherein the monitoring device (518) is suitable and configured for capturing by sensor the actuating zone (508) in which actuating takes place.

2. The sleeve device (500) according to the preceding claim, wherein the braking device (1) is configured magnetorheologically, and wherein the braking device (1) comprises at least one magnetorheological medium (6) and at least one field generating device (113) for generating and controlling a magnetic and/or electric field strength, and wherein by means of the field generating device (113) the medium (6) can be influenced, so as to set the torque for the rotatability of the operating member (903).

3. The sleeve device (500) according to any of the preceding claims, wherein the actuating position of the operating member (503) can be captured by means of at least one sensor device (505), and wherein the braking device (1) can be actuated by means of at least one control device (506) at least in dependence on the actuating position of the operating member (503), and wherein the damping is adjustable in dependence on at least one rotation angle of the operating member (503) captured by means of the sensor device (505), and is in particular adapted controlled.

4. The sleeve device (500) according to any of the preceding claims, wherein at least one control device (506) is comprised and is suitable and configured to actuate the braking device (1) at least in dependence on at least one control command, and to convert the control command to at least one haptic signal perceptible on the operating member (503), preferably a defined sequence of deceleration torques, so that the user can receive haptic feedback, at least due to an input made and/or during an input.

5. The sleeve device (500) according to any of the preceding claims, wherein the input device (502) can be coupled with the mobile device (510) wirelessly and/or wire-bound, so that the mobile device (510) accommodated in the sleeve part (501) can be operated by the input device (502), and/or such that the mobile device (510) can transmit signals to the input device (502).

6. The sleeve device (500) according to any of the preceding claims, comprising at least one sleeve part (501) with the input device (502) configuration optimized for right-handed persons, and/or comprising at least one sleeve part (501) with a configuration optimized for left-handed persons (502).

7. The sleeve device (500) according to any of the preceding claims, wherein the sleeve part (501) comprises at least two takeup devices (507) for taking up at least one input device (502) each, and wherein the input device (502) can be optionally inserted in one of the takeup devices (507).

8. The sleeve device (500) according to any of the preceding claims, wherein the actuating zones (508) are haptically discernible, to this end showing in particular different surfaces and/or surface structures and/or sizes and/or geometries and/or colors and/or materials, and/or wherein haptic feedback is provided in dependence on the actuating zone (508) in which the operating member (503) is actuated and in particular touched.

9. The sleeve device (500) according to any of the preceding claims, wherein at least one first movement of the operating member (503) allows to execute a first input and wherein onward movement of the operating member (503) allows to execute at least one further input, and wherein damping is provided different for the first movement and for the onward movement, and/or wherein the first movement is followed by at least one specific increase of the deceleration torque, so that any onward movement requires the application of additional force, and wherein the first movement of the operating member (503) causes at least one function to start, and wherein the onward movement of the operating member (503) causes at least an adaptation of the function.

10. The sleeve device (500) according to any of the preceding claims, wherein the control device (506) is suitable and configured for providing at least one haptic signal perceptible in the operating member (503), to serve as an aid for physically impaired persons.

11. The sleeve device (500) according to any of the preceding claims, wherein at least by moving, in particular rotating, the operating member (503), zooming and/or scrolling and/or camera selection and/or call control and/or menu selection, can be executed.

12. The sleeve device (500) according to any of the preceding claims, wherein at least by moving, in particular rotating, the operating member (503), an emphasis of a display area can be moved onward controlled, and in particular wherein the emphasis can be activated by pressing and/or rotating the operating member (503).

13. The sleeve device (500) according to any of the preceding claims, wherein the sleeve part (501) is configured foldable and comprises at least two sleeve sections (511), which are movably interconnected by at least one hinge device (509), and wherein the input device (502) is incorporated in the hinge device (509) .

14. The sleeve device (500) according to any of the preceding claims, wherein the sleeve part (501) is configured foldable and comprises at least two sleeve sections (511), which are movably interconnected by at least one hinge device (509), wherein the hinge device (509) is provided with at least one braking device (1), and wherein the braking device (1) is suitable and configured for controlled damping of the movement of the sleeve sections (511) relative to one another, and wherein the braking device (1) is configured magnetorheologically.

15. A mobile device (510), in particular a smartphone or tablet or other type of handheld respectively mobile smart device, comprising at least one device body (520) and at least one input device (502) for actuating device functions, wherein the input device (502) comprises at least one movable operating member (503) and at least one braking device (1), and wherein movement of the operating member (503) can be damped controlled by means of the braking device (1),
**characterized in**
**that** the major part of the input device (502) is disposed inside of the device body (520), that the operating member (503) comprises at least two actuating zones (508), wherein the movement of the operating member (503) can be damped controlled in dependence on the actuating zone (508) in which the operating member (503) is actuated and in particular touched, and that the mobile device (510) comprises at least one monitoring device (518), wherein the monitoring device (518) is suitable and configured for capturing by sensor the actuating zone (508) in which actuating takes place.

## Revendications

1. Dispositif de coque (500) pour un appareil mobile (510), en particulier un smartphone ou une tablette ou d'autres types d'appareils portables ou bien de dispositifs intelligents mobiles, comprenant au moins une partie de coque (501) pour envelopper au moins en partie ledit appareil mobile (510) et au moins un dispositif de saisie (502) qui est disposé au moins en partie dans la partie de coque (501) et destiné à commander l'appareil mobile (510) qui peut être logé dans la partie de coque (501),
dans lequel le dispositif de saisie (502) comprend au moins un élément de manoeuvre (503) déplaçable et au moins un dispositif de freinage (1), et dans lequel un mouvement de l'élément de manoeuvre (503) peut être amorti de manière ciblée au moyen du dispositif de freinage (1),
**caractérisé par le fait**
**que** l'élément de manoeuvre (503) comprend au moins deux zones d'actionnement (508) et dans lequel le mouvement de l'élément de manoeuvre (503) peut être amorti de manière ciblée en fonction de la zone d'actionnement (508) dans laquelle l'élément de manoeuvre (503) est actionné et en particulier touché et que le dispositif de coque (500) comprend au moins un dispositif de surveillance (518), dans lequel le dispositif de surveillance (518) est adapté et conçu pour détecter par capteur dans quelle zone d'actionnement (508) l'actionnement a lieu.

2. Dispositif de coque (500) selon la revendication précédente, dans lequel le dispositif de freinage (1) est conçu de manière magnétorhéologique et dans lequel le dispositif de freinage (1) comprend au moins un milieu magnétorhéologique (6) et au moins un dispositif générateur de champ (113) pour générer et commander une intensité de champ magnétique et/ou électrique et dans lequel le milieu (6) peut être influencé au moyen du dispositif générateur de champ (113) afin de régler le couple pour la capacité de rotation de l'élément de manoeuvre (903).

3. Dispositif de coque (500) selon l'une quelconque des revendications précédentes, dans lequel une position d'actionnement de l'élément de manoeuvre (503) peut être détectée au moyen d'au moins un dispositif capteur (505) et dans lequel le dispositif de freinage (1) peut être commandé au moyen d'au moins un dispositif de commande (506) au moins en fonction de la position d'actionnement de l'élément de manoeuvre (503) et dans lequel l'amortissement peut être réglé en fonction d'au moins un angle de rotation de l'élément de manoeuvre (503), détecté au moyen du dispositif capteur (505), et est en particulier adapté de manière ciblée.

4. Dispositif de coque (500) selon l'une quelconque des revendications précédentes, dans lequel au moins un dispositif de commande (506) est compris et est adapté et conçu pour commander le dispositif de freinage (1) au moins en fonction d'au moins un ordre de commande et pour transformer ledit ordre de commande en au moins un signal haptique perceptible sur l'élément de manoeuvre (503), de préférence en une séquence définie de moments de décélération de sorte qu'un utilisateur puisse recevoir un retour haptique au moins à la suite d'une saisie effectuée et/ou pendant une saisie.

5. Dispositif de coque (500) selon l'une quelconque des revendications précédentes, dans lequel le dispositif de saisie (502) peut être couplé sans fil et/ou par fil à l'appareil mobile (510) de sorte que ledit appareil mobile (510) logé dans la partie de coque (501) peut être manoeuvré par le dispositif de saisie (502) et/ou de sorte que ledit appareil mobile (510) peut envoyer des signaux au dispositif de saisie (502).

6. Dispositif de coque (500) selon l'une quelconque des revendications précédentes, comprenant au moins une partie de coque (501) avec un agencement du dispositif de saisie (502), qui est optimisé pour les droitiers et/ou comprenant au moins une partie de coque (501) avec un agencement du dispositif de saisie (502), qui est optimisé pour les gauchers.

7. Dispositif de coque (500) selon l'une quelconque des revendications précédentes, dans lequel la partie de coque (501) comprend au moins deux dispositifs de réception (507) destinés à recevoir chacun au moins un dispositif de saisie (502) et dans lequel le dispositif de saisie (502) peut être inséré au choix dans l'un des dispositifs de réception (507).

8. Dispositif de coque (500) selon l'une quelconque des revendications précédentes, dans lequel les zones d'actionnement (508) sont haptiquement distinguables et présentent à cette fin en particulier une surface et/ou une structure de surface et/ou une taille et/ou une géométrie et/ou une couleur et/ou un matériau différent(e)(s) et/ou dans lequel un retour haptique se produit en fonction de la zone d'actionnement (508) dans laquelle l'élément de manoeuvre (503) est actionné et en particulier touché.

9. Dispositif de coque (500) selon l'une quelconque des revendications précédentes, dans lequel une première saisie peut être effectuée par au moins un premier mouvement de l'élément de manoeuvre (503) et dans lequel au moins une autre saisie peut être effectuée en continuant à déplacer l'élément de manoeuvre (503) et dans lequel l'amortissement prévu pour le premier mouvement est différent de celui prévu pour la continuation de déplacement et/ou dans lequel, après le premier mouvement, il y a au moins une augmentation ciblée du couple de décélération de sorte qu'un déploiement de force supplémentaire est nécessaire pour la continuation de déplacement et dans lequel au moins une fonction est démarrée par le premier mouvement de l'élément de manoeuvre (503) et dans lequel au moins une adaptation de la fonction se fait en continuant à déplacer l'élément de manoeuvre (503).

10. Dispositif de coque (500) selon l'une quelconque des revendications précédentes, dans lequel le dispositif de commande (506) est adapté et conçu pour fournir au moins un signal haptique perceptible sur l'élément de manoeuvre (503), qui sert d'assistance à des personnes ayant une déficience.

11. Dispositif de coque (500) selon l'une quelconque des revendications précédentes, dans lequel une action de zoomer et/ou un défilement et/ou une sélection de caméra et/ou une commande d'appel et/ou une sélection de menu peut être effectué(e) par au moins un mouvement, en particulier une rotation, de l'élément de manoeuvre (503).

12. Dispositif de coque (500) selon l'une quelconque des revendications précédentes, dans lequel une mise en évidence d'une zone d'affichage peut être poussée plus loin de manière ciblée par au moins un mouvement, en particulier une rotation, de l'élément de manoeuvre (503), et en particulier dans lequel la mise en évidence peut être activée en appuyant sur et/ou en tournant l'élément de manoeuvre (503).

13. Dispositif de coque (500) selon l'une quelconque des revendications précédentes, dans lequel la partie de coque (501) est conçue pour être pliable et comprend au moins deux sections de coque (511) qui sont reliées de manière déplaçable par au moins un dispositif à charnière (509) et dans lequel le dispositif de saisie (502) est intégré au dispositif à charnière (509).

14. Dispositif de coque (500) selon l'une quelconque des revendications précédentes, dans lequel la partie de coque (501) est conçue pour être pliable et comprend au moins deux sections de coque (511) qui sont reliées de manière déplaçable par au moins un dispositif à charnière (509), dans lequel le dispositif à charnière (509) est équipé d'au moins un dispositif de freinage (1) et dans lequel le dispositif de freinage (1) est adapté et conçu pour amortir de manière ciblée le mouvement des sections de coque (511) les unes par rapport aux autres et dans lequel le dispositif de freinage (1) est conçu de manière magnétorhéologique.

15. Appareil mobile (510), en particulier smartphone ou tablette ou autre type d'appareil portable ou bien de dispositif intelligent mobile, comprenant au moins un corps d'appareil (520) et au moins un dispositif de saisie (502) pour commander des fonctions d'appareil,
dans lequel le dispositif de saisie (502) comprend au moins un élément de manoeuvre mobile (503) et au moins un dispositif de freinage (1), et dans lequel un mouvement de l'élément de manoeuvre (503) peut être amorti de manière ciblée au moyen du dispositif de freinage (1), **caractérisé par le fait que** le dispositif de saisie (502) est disposé pour une partie principale à l'intérieur du corps d'appareil (520), que l'élément de manoeuvre (503) comprend au moins deux zones d'actionnement (508), dans lequel le mouvement de l'élément de manoeuvre (503) peut être amorti de manière ciblée en fonction de la zone d'actionnement (508) dans laquelle l'élément de manoeuvre (503) est actionné et en particulier touché, et que l'appareil mobile (510) comprend au moins un dispositif de surveillance (518), dans lequel le dispositif de surveillance (518) est adapté et conçu pour détecter par capteur dans quelle zone d'actionnement (508) l'actionnement a lieu.
